# EUROPEAN PATENT APPLICATION

(11) **EP 2 485 267 A1**
(43) Date of publication of application: **08.08.2012**
(21) Application number: 09850051.5
(22) Date of filing: 30.09.2009
(51) Int. Cl.: H01L 31/042

(54) **SOLAR CELL MODULE, SOLAR CELL PANEL, SOLAR CELL MODULE MANUFACTURING METHOD, AND SOLAR CELL PANEL MANUFACTURING METHOD**

(71) Applicant: Mitsubishi Heavy Industries, Ltd., Tokyo 108-8215 (JP)
(72) Inventor: MAEDA, Katsuhiko, Tokyo 108-8215 (JP); HORIOKA, Tatsuji, Tokyo 108-8215 (JP); OOKA, Junji, Tokyo 108-8215 (JP); KITAMURA, Takashi, Tokyo 108-8215 (JP); MAMASE, Shinichiro, Tokyo 108-8215 (JP)
(74) Representative: Bongiovanni, Simone
(86) International application number: PCT/JP2009/067053
(87) International publication number: WO 2011/039860

(57) **Abstract**

A solar cell module, a solar cell panel, a process for producing a solar cell module and a process for producing a solar cell panel that are capable of inhibiting EVA protrusions and recesses, and capable of inhibiting penetration of moisture into the interior of the solar cell module. The solar cell module comprises a transparent substrate (11A) and a back substrate (11B) disposed across a photovoltaic layer, an inner seal portion (26A) disposed between, and surrounding the periphery of, the transparent substrate (11A) and the back substrate (11B), a gap (26C) formed in a portion of the inner seal portion (26A) and linking a region in which an encapsulant is disposed with the outside, an encapsulant disposed inside the region surrounded by the transparent substrate (11A), the back substrate (11B) and the inner seal portion (26A), and an outer seal portion that covers the gap (26C).

## Description

### Technical Field

The present invention relates to a solar cell module, a solar cell panel, a process for producing a solar cell module and a process for producing a solar cell panel, and relates particularly to a thin-film solar cell module, a solar cell panel, a process for producing a solar cell module and a process for producing a solar cell panel in which the electric power generation layer is formed by deposition.

### Background Art

Conventional solar cell panels are produced by forming a thin-film silicon-based solar cell on a glass substrate having a thickness of approximately 4 mm and dimensions of approximately 1.4 m × approximately 1.1 m, sealing the structure using a sealing material (EVA) and a backing sheet (having a PET/Al/PET structure), and then attaching the sealed structure to an aluminum frame.

The material cost of the above-mentioned aluminum frame represents approximately 10% to approximately 20% of the total materials cost of the solar cell panel, meaning the aluminum frame is one of the most expensive materials used in the production of the solar cell panel.

Accordingly, it is thought that abbreviating or simplifying the aluminum frame should be effective in reducing the production cost of a solar cell panel having the type of structure outlined above.

Specifically, by replacing the backing sheet disposed on the back surface of the solar cell panel with a glass substrate, and allowing the glass substrate to bear at least some of the strength load borne by the aluminum frame, the aluminum frame can be abbreviated or simplified (for example, see PTL 1).

This type of structure in which glass substrates are positioned on both the front surface and the back surface of the solar cell panel is referred to as a double glass structure in the following description.

On the other hand, in the case of solar cell panels having a backing sheet or the like on the back surface, the solar cell module is sometimes secured to the aluminum frame by inserting the edges of the solar cell module in a U-shaped edge within the aluminum frame.

However, if this type of solar cell panel is installed on an inclined surface, then a problem arises in that the electric power generation surface area of the solar cell panel is reduced.

In other words, a level difference is formed at the securing portions between the sunlight-incident side of the solar cell module surface and the aluminum frame, and when the solar cell panel is installed on an inclined surface, moisture and dust tend to accumulate at the level difference on the low side of the incline. This moisture or dust blocks incident light from entering the solar cell panel, resulting in an associated reduction in the electric power generation surface area.

In the case of solar cell panels having the double glass structure described above, because the aluminum frame that supports the solar cell module is abbreviated or simplified, no portion of the aluminum frame is positioned on the surface of the solar cell module where incident light enters the module. As a result, moisture or dust does not accumulate on the surface where incident light enters the module in the manner described above, meaning there is no reduction in the electric power generation surface area.

### Citation List

### Patent Literature

{PTL 1} Japanese Unexamined Patent Application, Publication No. Sho 61-199674

### Summary of Invention

### Technical Problem

A lamination step for a solar cell module having a double glass structure, namely the step of bonding a back glass substrate to a transparent glass substrate and sealing the space between the two glass substrates, is generally performed in the manner described below.

Namely, EVA (ethylene-vinyl acetate copolymer resin) is applied around the entire periphery of the transparent glass substrate on which the electric power generation layer has been formed, and the back glass substrate is then positioned so as to sandwich the electric power generation layer and the EVA between the transparent glass substrate and the back glass substrate. The lamination step is then performed by using a laminator to evacuate internal air, while the transparent glass substrate, the EVA and the back glass substrate and the like are heated using a hot plate, and the transparent glass substrate and the back glass substrate are pressed tightly together. During this step, the EVA undergoes cross-linking, thereby bonding the back glass substrate to the transparent glass substrate.

In the lamination step, in some cases the air within the internal space between the transparent glass substrate and the back glass substrate may not be able to be evacuated satisfactorily during sealing of the photovoltaic layer and an encapsulant and the like between the transparent glass substrate and the back glass substrate. In such cases, air bubbles are retained inside the solar cell module, namely in the space between the transparent substrate and the back substrate. These air bubbles can act as moisture penetration paths through which moisture can enter the interior of the solar cell module from the module periphery, causing a deterioration in the long-term reliability of the EVA sealing portion.

Furthermore, in the lamination step, if a surface pressure distribution exists during the pressing of the transparent glass substrate and the back glass substrate, then there is a possibility that the EVA may protrude externally from the periphery of the solar cell module, and particularly from the corner portions, or that following completion of the pressing, the EVA may recede inside the edges of the solar cell module, forming a gap. If this type of gap is formed, then a problem arises in that the sealing performance of the EVA sealing portion that prevents moisture from entering the module tends to deteriorate, causing a deterioration in the long-term reliability of the sealing portion.

In large solar cell modules having a surface area exceeding 1 m², achieving a state of uniform pressure across the entire solar cell module is particularly difficult. Moreover, the occurrence of warping due to a heat distribution across the substrates also increases the possibility of the EVA protruding externally from the periphery of the substrates, or the EVA receding inside the edges of the solar cell module. Accordingly, an effective countermeasure for achieving a state of uniform pressure across the entire solar cell module, and an effective countermeasure for preventing the EVA from protruding externally or receding internally have been keenly sought.

It is thought that whereas external protrusion of the EVA occurs when the substrate spacing between the transparent glass substrate and the back glass substrate is closer at the substrate periphery than at the substrate center, internal receding of the EVA occurs in the manner described below.

Namely, if the compression force during the lamination step results in a state where the substrate spacing between the transparent glass substrate and the back glass substrate at the periphery of the solar cell module, and particularly at the corner portions of the module, is much closer than the spacing in the overall region composed of mainly the central portion of the solar cell module, and the lamination step is ended and the compression force removed in this state, then the spacing between the transparent glass substrate and the back glass substrate at those portions (the corner portions) where the substrate spacing was overly close tends to expand and approach the substrate spacing in the central portion of the substrates. As a result, the EVA positioned between the transparent glass substrate and the back glass substrate is drawn back inside the module, causing recesses at the peripheral portions of the solar cell module.

In this description, the structure produced following completion of the lamination step is termed a "solar cell module", whereas the product produced following completion of all of the production steps is termed a "solar cell panel".

The present invention has been developed to address the issues described above, and has an object of providing a solar cell module, a solar cell panel, a process for producing a solar cell module and a process for producing a solar cell panel that are capable of inhibiting EVA protrusions and recesses and the like, and capable of inhibiting penetration of moisture into the interior of the solar cell module.

### Solution to Problem

In order to achieve the above object, the present invention provides the aspects described below.

A first aspect of the present invention provides a solar cell module comprising: a transparent substrate and a back substrate that are disposed with a photovoltaic layer sandwiched therebetween, an inner seal portion that is disposed between the transparent substrate and the back substrate and surrounds the periphery of the region between the transparent substrate and the back substrate, an encapsulant that is disposed inside the region surrounded by the transparent substrate, the back substrate and the inner seal portion, a gap that is formed in a portion of the inner seal portion and links the region in which the encapsulant is disposed with the outside, and an outer seal portion that covers the gap.

According to the first aspect of the present invention, because the encapsulant is disposed in the space surrounded by the transparent substrate, the back substrate and the inner seal portion, protrusion of the encapsulant from between the transparent substrate and the back substrate can be prevented during the process of sealing the space in which the encapsulant is disposed.

Moreover, because the inner seal portion is disposed between the transparent substrate and the back substrate, the inhibitory properties that inhibit moisture from penetrating into the interior of the solar cell module, namely the region in which the photovoltaic layer is disposed, are able to be maintained.

On the other hand, during the process of sealing the photovoltaic layer and the encapsulant and the like between the transparent substrate and the back substrate, air can be evacuated from the space surrounded by the transparent substrate, the back substrate and the inner seal portion via the gap that has been formed in the inner seal portion. Accordingly, retention of air bubbles in the interior of the solar cell module, namely between the transparent substrate and the back substrate, can be prevented. This enables suppression of the problem wherein these air bubbles act as moisture penetration paths through which moisture can enter the interior of the solar cell module from the module periphery, meaning the long-term reliability of the solar cell module can be improved.

Moreover, following sealing of the photovoltaic layer and the encapsulant and the like between the transparent substrate and the back substrate, sealing of the interior of the solar cell module can be achieved by covering the outer periphery of the gap with the outer seal portion.

In the first aspect of the present invention described above, the above-mentioned gap is preferably provided in only a single location within the inner seal portion.

According to this invention, in those cases where, for example, the solar cell module of the present invention is installed on an inclined installation surface, by installing the solar cell module so that the gap in the inner seal portion is positioned on the upper side of the inclined installation surface, penetration of moisture into the interior of the solar cell module can be suppressed.

In other words, moisture such as rain water tends to penetrate between the solar cell module and the frame that supports the solar cell module. In those cases where the solar cell module is installed on an inclined surface, and the installation and drainage structure of the solar cell panel results in the generation of a moisture retention region at the bottom of the solar cell panel, moisture tends to accumulate at the bottom of the inclined surface. Accordingly, by positioning the gap in the inner seal portion at the upper side of the installation surface, any accumulated water can be distanced from the gap in the inner seal portion. As a result, moisture penetration due to the accumulated water is prevented by the sealed structure formed from the continuous inner seal portion, the gap in the inner seal portion is located in a position distant from the accumulated water, and the outer periphery of the gap is covered by the outer seal portion, meaning penetration of moisture into the interior of the solar cell module can be effectively suppressed.

In the first aspect of the present invention described above, the gap is preferably provided at a corner of the inner seal portion.

According to this invention, by forming the gap at a corner of the inner seal portion, the inner seal portion can be provided in a stable manner.

For example, in those cases where the inner seal portion is formed by application using a dispenser or the like, the corners where the direction of application changes tend to be prone to non-uniformity in the thickness of the applied inner seal portion, or non-uniformity in the shape of the inner seal portion. By forming the gap at a corner of the inner seal portion, the inner seal portion need not be formed at the corner, where formation tends to be difficult, meaning the uniformity of the thickness and shape of the inner seal portion can be more readily maintained.

On the other hand, by providing a gap in the inner seal portion at each of the corners of the inner seal portion, the air within the space surrounded by the transparent substrate, the back substrate and the inner seal portion can be evacuated more uniformly than the case in which a gap is provided in only a single location within the inner seal portion.

Accordingly, retention of air bubbles within the interior of the solar cell module, namely within the space between the transparent substrate and the back substrate, can be better suppressed, and the problem wherein these air bubbles act as moisture penetration paths through which moisture can enter the interior of the solar cell module from the module periphery can be inhibited, meaning the long-term reliability of the solar cell module can be improved.

In the first aspect of the present invention described above, the inner seal portion is preferably disposed along one pair of opposing sides of the transparent substrate and the back substrate, and the gap is provided along the other pair of opposing sides.

According to this invention, because the inner seal portion need only be provided along two opposing edges, positioning and applying the inner seal portion is simplified. For example, in those cases where the inner seal portion is applied using a dispenser, because the direction of movement of the dispenser is restricted, the drive mechanism for the dispenser can be simplified.

A second aspect of the present invention provides a solar cell panel comprising the above-mentioned solar cell module of the first aspect of the present invention, and ribs that are affixed to the back substrate of the solar cell module and support the solar cell module.

According to the second aspect of the present invention, the ribs that are affixed to the back substrate and support the solar cell module can function as members that impart additional strength to the solar cell module. As a result, the strength of the back substrate itself may be quite low, and the thickness of the back substrate can be reduced, meaning the material cost of the back substrate can also be reduced.

Moreover, by reducing the thickness of the back substrate, the mass of the solar cell panel can be reduced to produce a more lightweight structure, even allowing for the mass increase due to the ribs, which improves handling of the solar cell panel during production and installation.

A third aspect of the present invention provides a process for producing a solar cell module, the process comprising a deposition step of forming a photovoltaic layer on a transparent substrate, a positioning step of positioning an inner seal portion around the periphery of the transparent substrate, forming a notch-shaped gap in a portion of the inner seal portion, and positioning an encapsulant inside the region surrounded by the inner seal portion, and a sealing step of positioning a back substrate so as to sandwich the inner seal portion and the encapsulant between the transparent substrate and the back substrate, evacuating the air from the space surrounded by the inner seal portion, and heat-sealing the encapsulant to seal the transparent substrate and the back substrate.

According to the third aspect of the present invention, because the encapsulant is provided in the space surrounded by the transparent substrate, the back substrate and the inner seal portion during the positioning step, protrusion of the encapsulant from the space between the transparent substrate and the back substrate can be prevented.

Moreover, because the inner seal portion is disposed between the transparent substrate and the back substrate, the inhibitory properties that inhibit moisture from penetrating into the interior of the solar cell module, namely the region in which the photovoltaic layer is disposed, are able to be maintained.

On the other hand, in the sealing step of sealing the photovoltaic layer and the encapsulant and the like between the transparent substrate and the back substrate, air within the space surrounded by the transparent substrate, the back substrate and the inner seal portion can be evacuated via the gap formed in the inner seal portion. Accordingly, retention of air bubbles in the interior of the solar cell module, namely between the transparent substrate and the back substrate, can be prevented. This enables suppression of the problem wherein these air bubbles act as moisture penetration paths through which moisture can enter the interior of the solar cell module from the module periphery, thus improving the long-term reliability of the solar cell module.

A fourth aspect of the present invention provides a process for producing a solar cell module, the process comprising a deposition step of forming a photovoltaic layer on a transparent substrate, a positioning step of positioning an encapsulant so as to cover the photovoltaic layer on the transparent substrate, and a sealing step of positioning a back substrate so as to sandwich the photovoltaic layer and the encapsulant between the transparent substrate and the back substrate, positioning a pillow that specifies the spacing between the transparent substrate and the back substrate along at least a portion of the periphery of the transparent substrate, evacuating the air from the space between the transparent substrate and the back substrate, and heat-sealing the encapsulant to seal the transparent substrate and the back substrate.

According to the fourth aspect of the present invention, the spacing between the transparent substrate and the back substrate is prevented from narrowing beyond a predetermined spacing specified by the pillow. As a result, the encapsulant can be prevented from being pushed out and protruding from between the transparent substrate and the back substrate during the sealing step.

Moreover, following completion of the sealing step, the spacing between the transparent substrate and the back substrate does not widen, meaning the encapsulant can be prevented from receding into the space between the transparent substrate and the back substrate.

As a result, the problem wherein recesses in the encapsulant act as moisture penetration paths through which moisture can enter the interior of the solar cell module from the module periphery is prevented, and the long-term reliability of the solar cell module is improved.

In the third aspect or fourth aspect of the present invention, the sealing step preferably includes an outer periphery sealing step of positioning an outer seal portion so as to cover the outer periphery of those regions between the transparent substrate and the back substrate in which the inner seal portion has not been provided.

According to this invention, following the sealing step of sealing the photovoltaic layer and the like between the transparent substrate and the back substrate, the outer periphery of those regions between the transparent substrate and the back substrate in which the inner seal portion has not been provided is covered by the outer seal portion, and therefore favorable sealing of the interior of the solar cell module can be achieved.

A fifth aspect of the present invention provides a process for producing a solar cell panel, the process comprising a rib attachment step, which is performed following the sealing step of the above-mentioned process for producing a solar cell module according to the present invention, and comprises attaching ribs that support the solar cell module to the back substrate.

According to the fifth aspect of the present invention, the ribs that are affixed to the back substrate and support the solar cell module can function as members that impart additional strength to the solar cell module. Accordingly, the strength of the back substrate itself may be quite low, and the thickness of the back substrate can be reduced, meaning the material cost of the back substrate can also be reduced.

Moreover, by reducing the thickness of the back substrate, the mass of the solar cell panel can be reduced to produce a more lightweight structure, even allowing for the mass increase due to the ribs, which improves handling of the solar cell panel during production and installation.

### Advantageous Effects of Invention

In the solar cell module according to the first aspect of the present invention, the solar cell panel according to the second aspect, the process for producing a solar cell module according to the third aspect, and the process for producing a solar cell panel according to the fifth aspect, the encapsulant is disposed in the space surrounded by the transparent substrate, the back substrate and the inner seal portion, and air within the space surrounded by the transparent substrate, the back substrate and the inner seal portion can be evacuated via the gap formed in the inner seal portion, and therefore protrusions and recesses within the encapsulant (such as EVA) can be inhibited, and penetration of moisture into the interior of the solar cell module can be suppressed.

In the process for producing a solar cell module according to the fourth aspect of the present invention and the process for producing a solar cell panel according to the fifth aspect, the pillow that specifies the spacing between the transparent substrate and the back substrate is provided prior to sealing of the transparent substrate and the back substrate, and therefore protrusions and recesses within the encapsulant (such as EVA) can be inhibited, and penetration of moisture into the interior of the solar cell module can be suppressed.

### Brief Description of Drawings

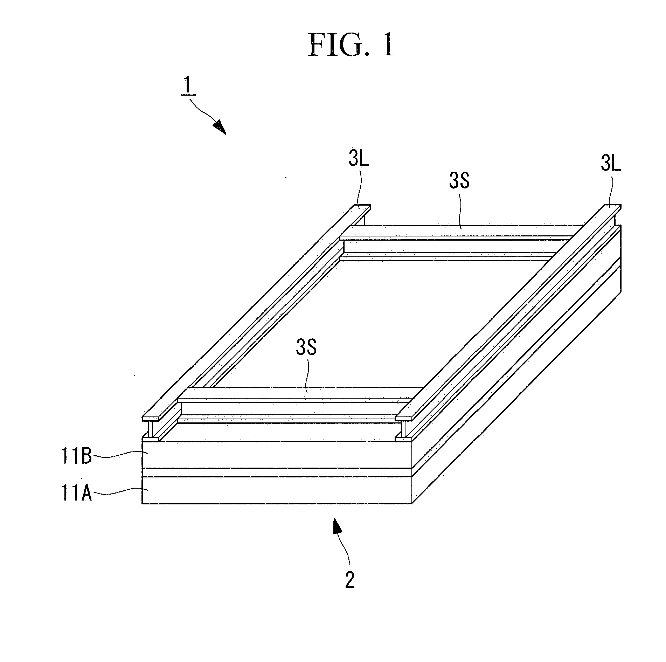

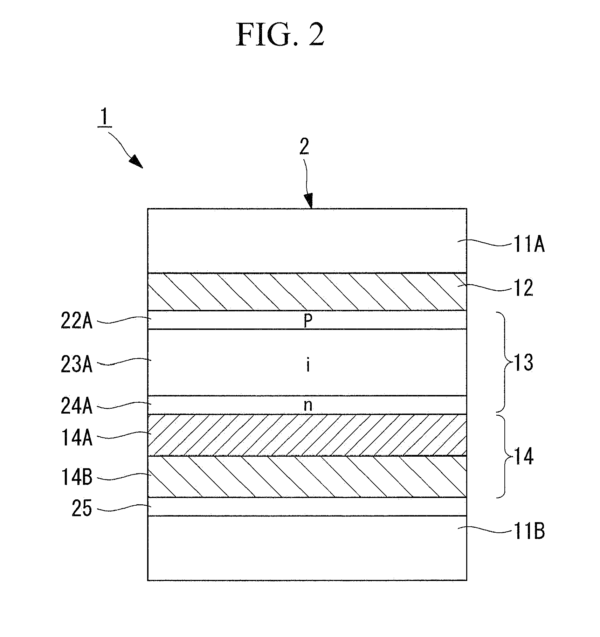

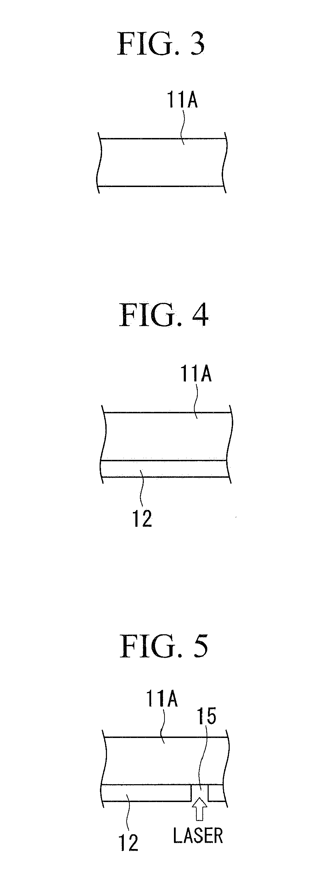

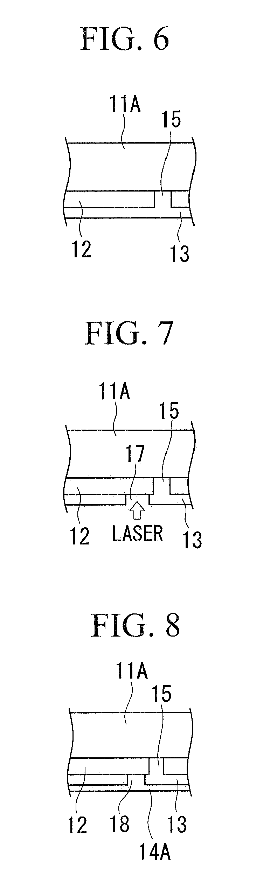

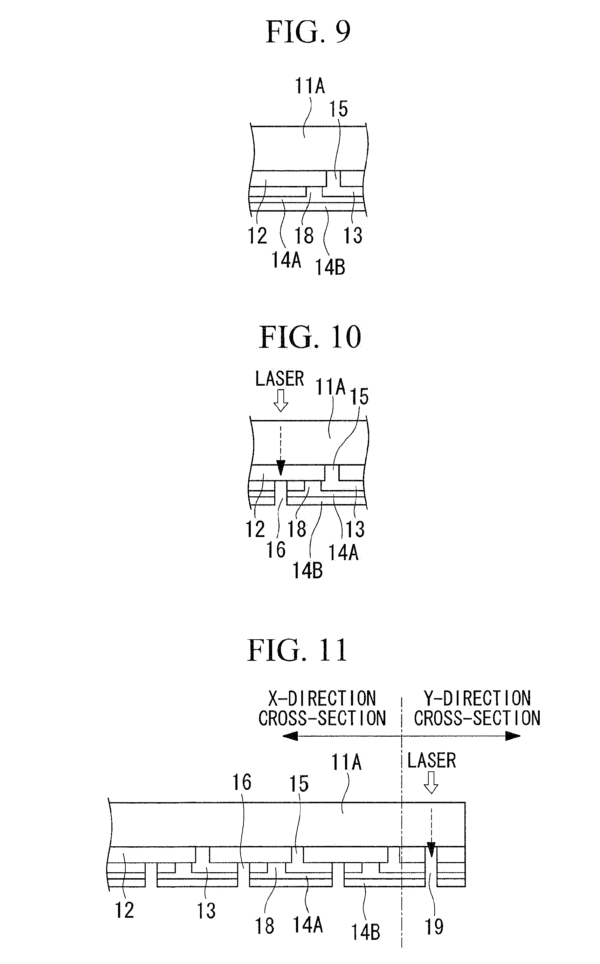

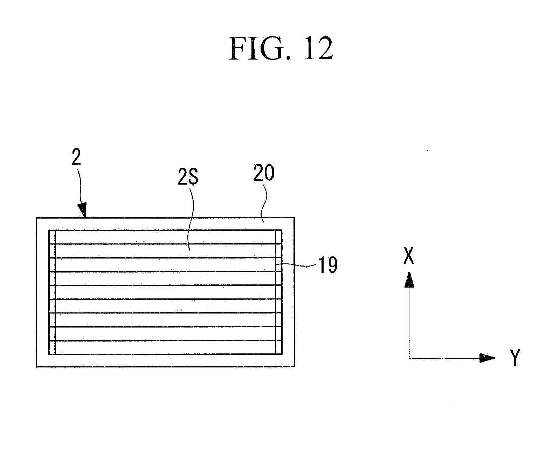

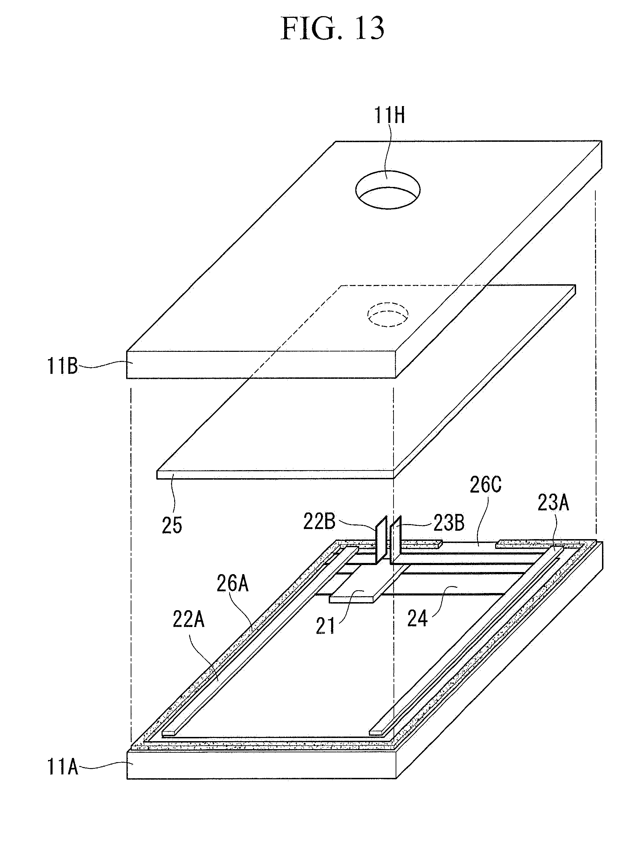

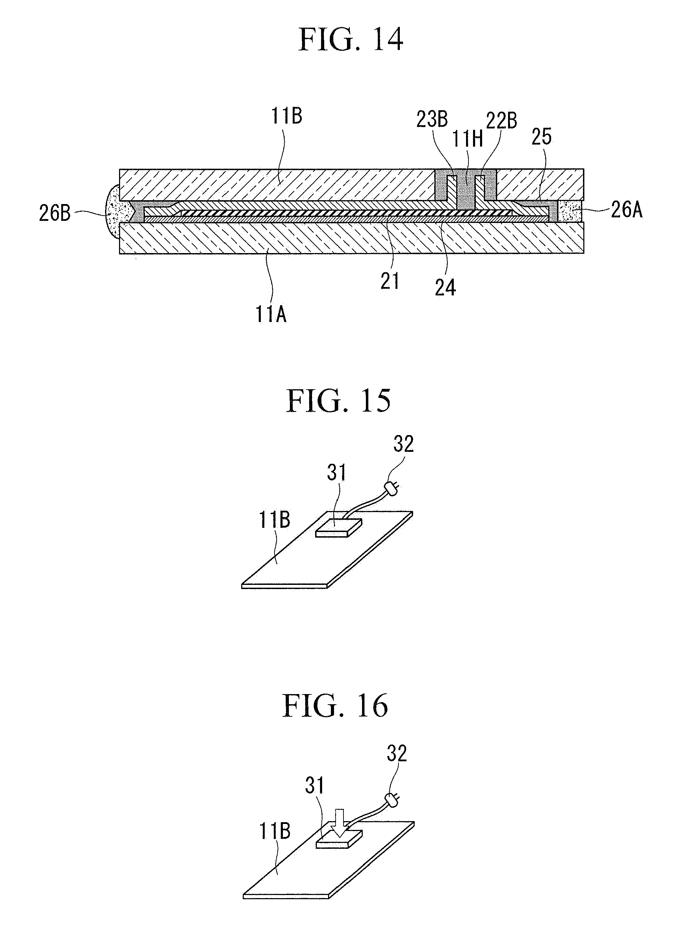

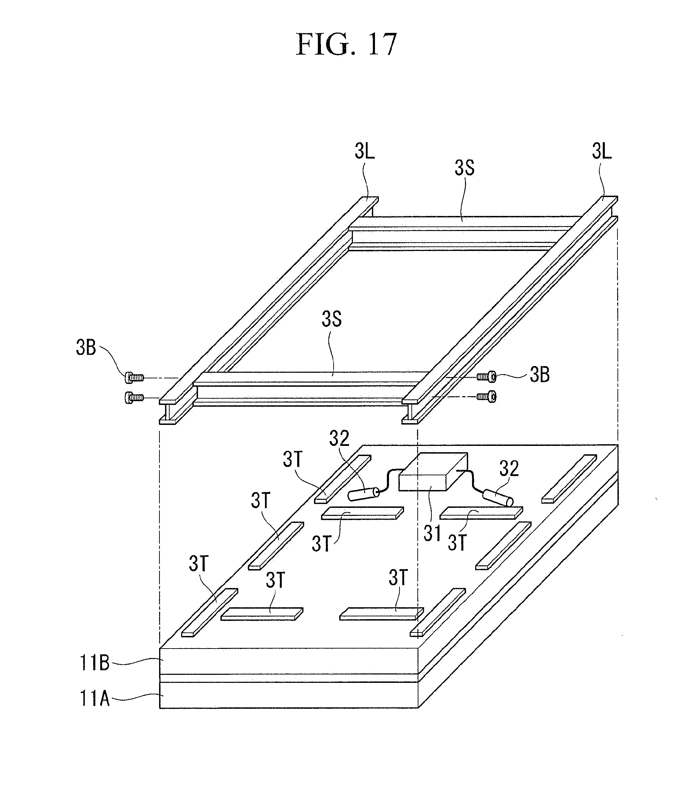

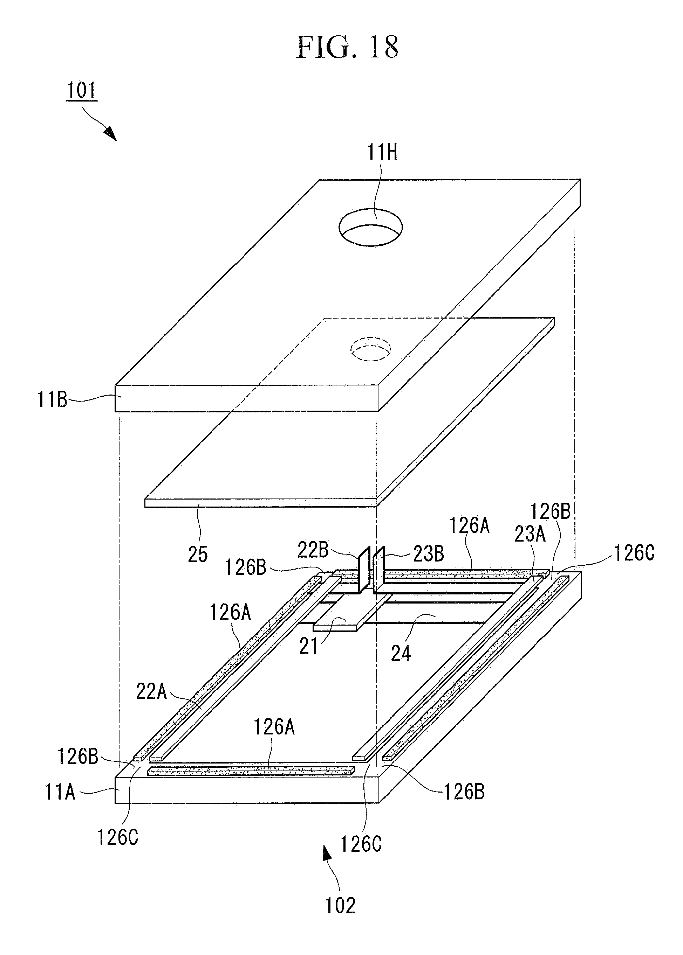

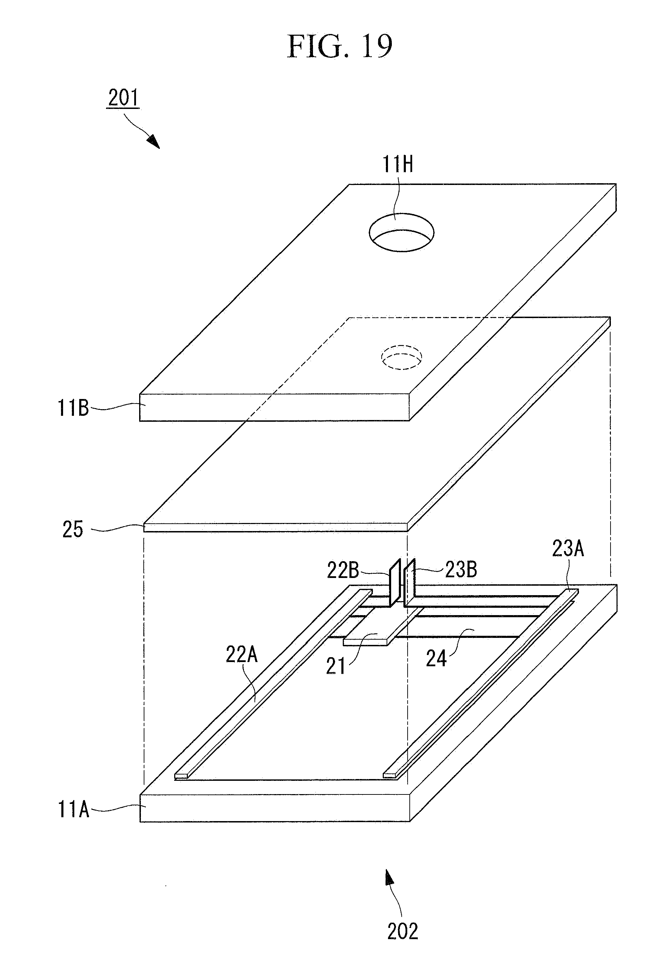

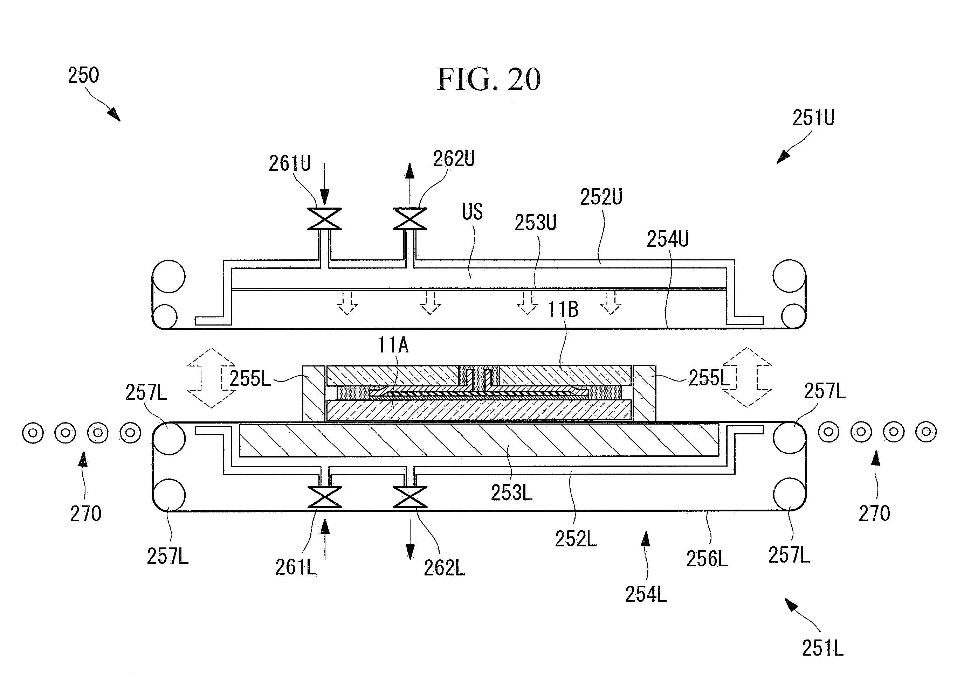

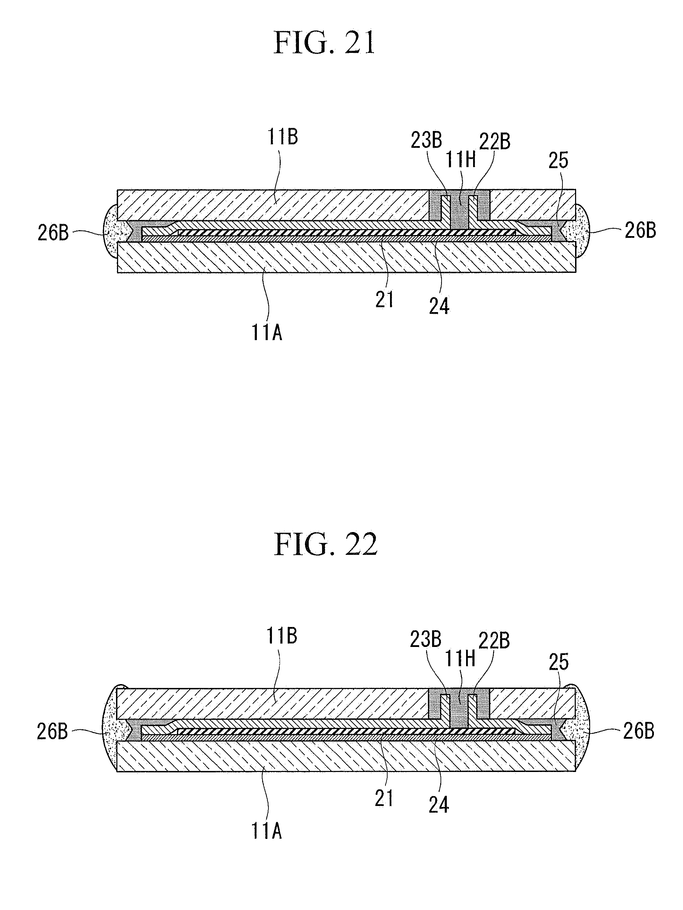

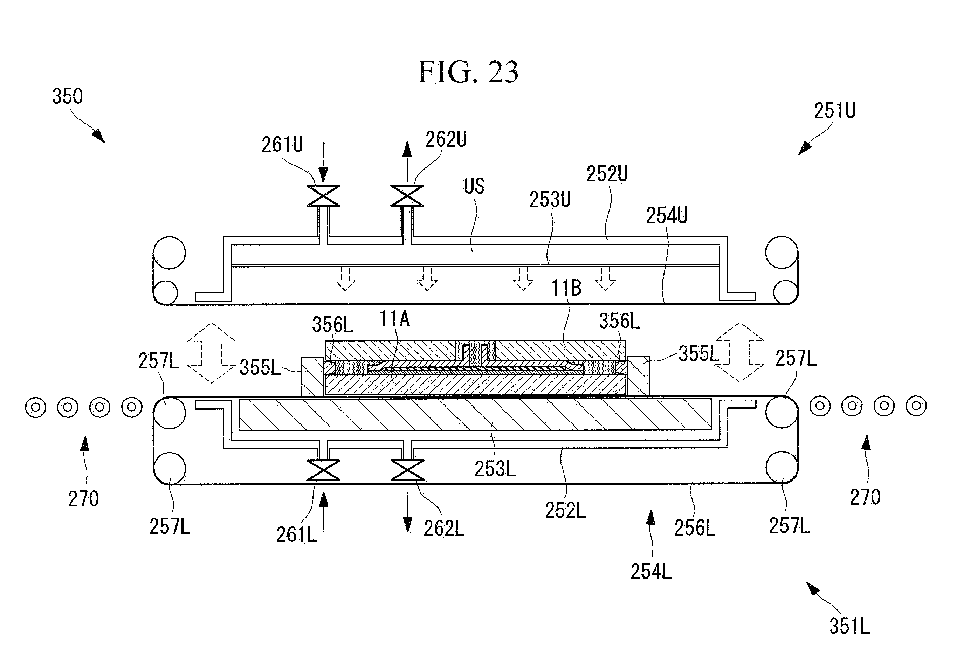

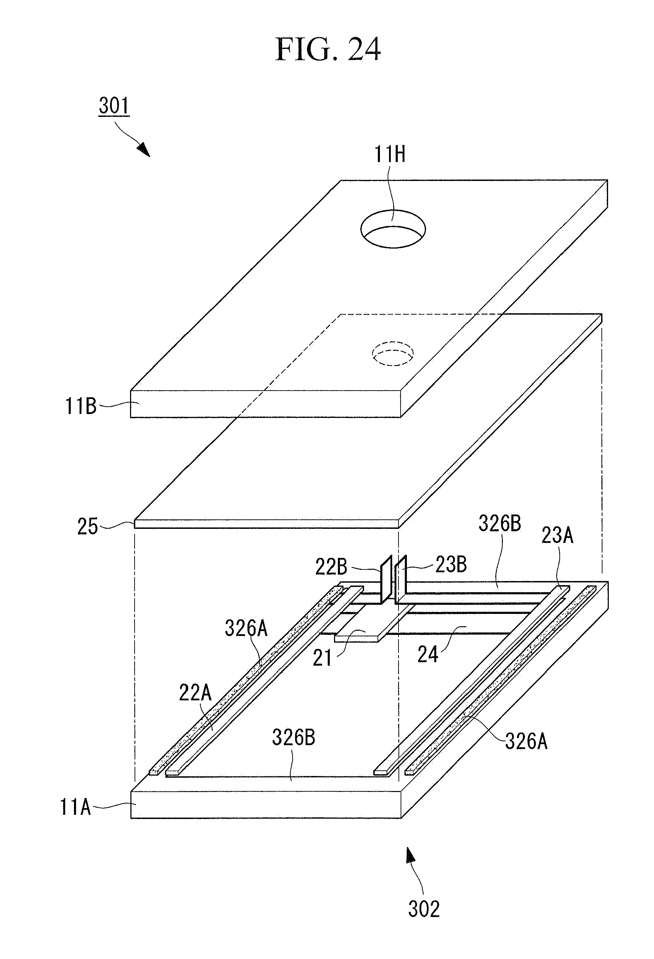

{Fig. 1} A schematic illustration describing the structure of a solar cell panel according to a first embodiment of the present invention.
{Fig. 2} A schematic illustration describing the structure of the solar cell module of Fig. 1.
{Fig. 3} A schematic illustration describing a production process for the solar cell module of Fig. 2.
{Fig. 4} A schematic illustration describing a step of forming a transparent electrode layer in the production process for the solar cell module of Fig. 2.
{Fig. 5} A schematic illustration describing a step of forming a transparent electrode layer slot in the production process for the solar cell module of Fig. 2.
{Fig. 6} A schematic illustration describing a step of stacking a photovoltaic layer in the production process for the solar cell module of Fig. 2.
{Fig. 7} A schematic illustration describing a step of forming a connection groove in the production process for the solar cell module of Fig. 2.
{Fig. 8} A schematic illustration describing a step of stacking a back electrode layer in the production process for the solar cell module of Fig. 2.
{Fig. 9} A schematic illustration describing a step of stacking a back electrode layer in the production process for the solar cell module of Fig. 2.
{Fig. 10} A schematic illustration describing a step of producing an isolation groove in the production process for the solar cell module of Fig. 2.
{Fig. 11} A schematic illustration describing a step of producing an insulation slot in the production process for the solar cell module of Fig. 2.
{Fig. 12} An illustration of the solar cell module viewed from the back electrode layer side, describing the formation of the insulation slot of Fig. 11.
{Fig. 13} A schematic illustration describing the stacking of a back substrate and the like on the transparent substrate and the like of Fig. 12.
{Fig. 14} A schematic cross-sectional view describing a step of applying an outer sealing material in the production process for the solar cell module of Fig. 2.
{Fig. 15} A schematic illustration describing a step of attaching a terminal box in the production process for the solar cell module of Fig. 2.
{Fig. 16} A schematic illustration describing a sealing step in the production process for the solar cell module of Fig. 2.
{Fig. 17} A schematic illustration describing a step of attaching long-side ribs and short-side ribs to the solar cell module.
{Fig. 18} A schematic illustration describing the locations of gaps in an inner periphery sealing material in a solar cell panel according to a second embodiment of the present invention.
{Fig. 19} A schematic illustration describing stacking of a back substrate and the like on a transparent substrate and the like in a solar cell panel according to a third embodiment of the present invention.
{Fig. 20} A schematic illustration describing the structure of a laminator.
{Fig. 21} A schematic illustration describing a step of applying an outer sealing material.
{Fig. 22} A schematic illustration describing a different structural state for the outer sealing material from the structural state illustrated in Fig. 21.
{Fig. 23} A schematic illustration describing the structure of a laminator according to the third embodiment of the present invention.
{Fig. 24} A schematic illustration describing the locations of gaps in the inner periphery sealing material in a solar cell panel according to a fourth embodiment of the present invention.

### Description of Embodiments

### First Embodiment

A solar cell panel according to a first embodiment of the present invention is described below with reference to Fig. 1 to Fig. 17.

Fig. 1 is a schematic illustration describing the structure of a solar cell panel according to this embodiment.

The solar cell panel 1 described in this embodiment is a silicon-based solar cell panel comprising a solar cell module 2, and as illustrated in Fig. 1, the solar cell panel 1 is provided with a pair of long-side ribs 3L, 3L, and a pair of short-side ribs 3S, 3S.

Fig. 2 is a schematic illustration describing the structure of the solar cell module of Fig. 1.

As illustrated in Fig. 2, the solar cell module 2 comprises mainly a transparent substrate 11A, a transparent electrode layer 12, a photovoltaic layer 13, a back electrode layer 14, an encapsulant sheet 25, and a back substrate 11B.

The transparent substrate 11A is a glass substrate, and typically employs a soda float glass or pressed glass or the like. Further, glass types known as green sheet glass and white crown glass are commonly used as the glass material, and either of these glass types can be used as the substrate.

In terms of the transmission properties relative to light of 350 nm to 800 nm, which represents the light absorption wavelength of the photovoltaic layer 13, a white crown glass having a lower iron content and a higher degree of transmittance than a green sheet glass is preferred for the transparent substrate 11A. Further, in order to ensure sufficient strength for a solar cell module 2 having a surface area exceeding 1 m², the thickness of the glass substrate is preferably within a range from approximately 2.8 mm to approximately 4.5 mm, and is more preferably within a range from approximately 3.0 mm to approximately 3.2 mm.

When white crown glass is used as the transparent substrate 11A, the transmittance at a wavelength of 500 nm is at least 91%, and the transmittance at 1,000 nm is at least 89%. In contrast, when a green sheet glass is used, the transmittance at a wavelength of 500 nm is approximately 89%, and the transmittance at 1,000 nm is between approximately 75% and 80%, representing a slightly lower transmittance than white crown glass for these wavelengths.

Because it is not required to transmit light, the back substrate 11B is preferably a glass substrate formed from green sheet glass, which is significantly less expensive than white crown glass. Further, the back substrate 11B is preferably thinner than the transparent substrate 11A, with a thickness within a range from approximately 1.8 mm to approximately 3.2 mm, and more preferably within a range from approximately 2.0 mm to approximately 2.2 mm. Ensuring that the thickness of the back substrate 11B is less than that of the transparent substrate 11A, thereby lightening the back substrate 11B relative to the transparent substrate 11A, makes the production process for the solar cell module 2 somewhat easier.

The present embodiment is described in relation to the case where both the transparent substrate 11A and the back substrate 11B have a surface area exceeding 1 m² (for example, dimensions of 1.4 m × 1.1 m). Both substrates may or may not be subjected to corner chamfering or the like, and there are no particular limitations in this regard.

As illustrated in Fig. 1, the pair of long-side ribs 3L, 3L and the pair of short-side ribs 3S, 3S are fixed to the back substrate 11B of the solar cell module 2 and support the solar cell module 2. Moreover, the pair of long-side ribs 3L, 3L and the pair of short-side ribs 3S, 3S reinforce the strength of the back substrate 11B.

The present embodiment describes an example in which one pair of each of the long-side ribs 3L and the short-side ribs 3S are provided, but the number of long-side ribs 3L and short-side ribs 3S installed to ensure the required level of strength for the solar cell panel 1 is not limited to a pair.

Moreover, the present embodiment is described in relation to the case where both the long-side ribs 3L and the short-side ribs 3S are formed with an I-shaped cross-section, but the present invention is not limited to ribs with an I-shaped cross-section, provided the required level of strength for the solar cell panel 1 can be achieved.

The long-side ribs 3L are a pair of ribs that are disposed so as to extend along the long-side edges of the back substrate 11B. The short-side ribs 3S are a pair of ribs disposed across the space between the pair of long-side ribs 3L, and extend in a direction substantially parallel to the short-side edges of the back substrate 11B. The short-side ribs 3S are disposed at positions some distance toward the center from the short-side edges of the back substrate 11B.

In other words, the pair of long-side ribs 3L, 3L and the pair of short-side ribs 3S, 3S form a rectangular-shaped frame structure. The long-side ribs 3L and the short-side ribs 3S are fixed together using fastening members such as bolts 3B.

Next is a description of a process for producing the solar cell panel 1 having the structure described above.

The present embodiment describes the example of a solar cell panel 1 in which a single-layer amorphous silicon thin film is deposited as the photovoltaic layer 13 on a glass substrate that functions as the transparent substrate 11A.

The photovoltaic layer 13 is not limited to examples that employ a single-layer amorphous silicon solar cell. For example, the photovoltaic layer 13 may also be used within other varieties of thin-film solar cells such as crystalline silicon solar cells that employ microcrystalline silicon, silicon-germanium solar cells, and multi-junction (tandem) solar cells in which one layer, or a plurality of layers, of each of an amorphous silicon solar cell and a crystalline silicon solar cell or silicon-germanium solar cell are stacked together.

Moreover, an intermediate contact layer that functions as a semi-reflective film for improving the contact properties and achieving electrical current consistency may be provided between each of the plurality of layers of stacked thin-film solar cells. A transparent conductive film such as a GZO (Ga-doped ZnO) film may be used as the intermediate contact layer.

The photovoltaic layer 13 need not be limited to silicon-based thin-film solar cells, and the invention can also be applied in a similar manner to compound semiconductor-based (CIS-type, CIGS-type or CdTe-type) solar cells.

Moreover, the term "silicon-based" is a generic term that includes silicon (Si), silicon carbide (SiC) and silicon germanium (SiGe).

Further, the term "crystalline silicon-based" describes a silicon system other than an amorphous silicon system, and includes both microcrystalline silicon systems and polycrystalline silicon systems.

The present embodiment describes the case in which the photovoltaic layer 13 is prepared by stacking an amorphous silicon p-layer 13p, an amorphous silicon i-layer 13i and an amorphous silicon n-layer 13n.

Moreover, the present embodiment describes the case in which the back electrode layer 14 is prepared by stacking a first back electrode layer 14A and a second back electrode layer 14B.

Fig. 3 is a schematic illustration describing a production process for the solar cell module of Fig. 2.

First, as illustrated in Fig. 3, a glass substrate is prepared as the transparent substrate 11A. A white crown glass substrate that exhibits excellent transmittance of light having a wavelength of 350 nm to 800 nm, which represents the absorption wavelength of the photovoltaic layer 13, is preferred. The edges of the transparent substrate 11A are preferably subjected to corner chamfering or R-face chamfering.

Fig. 4 is a schematic illustration describing a step of forming a transparent electrode layer in the production process for the solar cell module of Fig. 2.

As illustrated in Fig. 4, the transparent electrode layer 12 is deposited on the transparent substrate 11A using a thermal CVD apparatus at temperature conditions of approximately 500°C.

The transparent electrode layer 12 is a transparent electrode film comprising mainly tin oxide (Sn0₂), and has a film thickness of approximately 500 nm to approximately 800 nm. During this deposition treatment, a texture comprising suitable asperity is formed on the surface of the tin oxide film.

Alternatively, the transparent electrode layer 12 may be formed without using a thermal CVD apparatus, by using sputtering or the like to form a transparent electrode film comprising mainly zinc oxide (ZnO₂).

An alkali barrier film (not shown in the figure) may or may not be formed between the transparent substrate 11A and the transparent electrode layer 12, and there are no particular limitations in this regard.

The alkali barrier film is formed, for example, using a thermal CVD apparatus to deposit a silicon oxide film (SiO₂) at a temperature of approximately 500°C. The thickness of the silicon oxide film is typically approximately 50 nm to approximately 150 nm.

Fig. 5 is a schematic illustration describing a step of forming a transparent conductive layer slot in the production process for the solar cell module of Fig. 2.

As illustrated in Fig. 5, following deposition of the transparent electrode layer 12, a transparent electrode layer slot 15 is formed.

Specifically, the transparent substrate 11A is mounted on an X-Y table, and the first harmonic of a YAG laser (1064 nm) is irradiated onto the surface of the transparent electrode layer 12, as shown by the arrow in the figure. The transparent electrode layer 12 is laser-etched by the laser light, forming the transparent electrode layer slot 15 across a width of approximately 6 mm to 15 mm. This transparent electrode layer slot 15 partitions the transparent electrode layer 12 into strips.

The power of the irradiated YAG laser is adjusted to ensure an appropriate process speed for the transparent electrode layer slot 15. The laser light irradiated onto the transparent electrode layer 12 is moved relative to the transparent substrate 11A, in a direction substantially perpendicular to the direction of the series connection of the electric power generation cells 2S (see Fig. 12).

Fig. 6 is a schematic illustration describing a step of stacking a photovoltaic layer in the production process for the solar cell module of Fig. 2.

As illustrated in Fig. 6, following formation of the transparent electrode layer slot 15, the photovoltaic layer 13 is stacked on the transparent electrode layer 12 (the deposition step).

Specifically, using a plasma-enhanced CVD apparatus, and using SiH₄ gas and H₂ gas as the main raw materials, the photovoltaic layer 13 is deposited under conditions including a reduced pressure atmosphere within a range from approximately 30 Pa to approximately 1,000 Pa and a temperature for the transparent substrate 11A that is maintained at approximately 200°C. As illustrated in Fig. 2, the photovoltaic layer 13 comprises the amorphous silicon p-layer 13p, the amorphous silicon i-layer 13i and the amorphous silicon n-layer 13n stacked in that order, with the p-layer 22A closest to the surface from which the incident light such as sunlight enters the module.

The present embodiment describes the case in which the amorphous silicon p-layer 13p comprises mainly B-doped amorphous SiC and has a thickness of approximately 10 nm to approximately 30 nm, the amorphous silicon i-layer 13i comprises mainly amorphous Si and has a thickness of approximately 200 nm to approximately 350 nm, and the amorphous silicon n-layer 13n comprises mainly a P-doped silicon layer in which microcrystalline silicon is incorporated within amorphous silicon, and has a thickness of approximately 30 nm to approximately 50 nm.

A buffer layer may be provided between the p-layer and the i-layer in order to improve the interface properties.

Fig. 7 is a schematic illustration describing a step of forming a connection groove in the production process for the solar cell module of Fig. 2.

As illustrated in Fig. 7, following stacking of the photovoltaic layer 13, a connection groove 17 is formed.

Specifically, the transparent substrate 11A is mounted on an X-Y table, and the second harmonic of a laser diode excited YAG laser (532 nm) is irradiated onto the surface of the photovoltaic layer 13, as shown by the arrow in the figure. The photovoltaic layer 13 is laser-etched, forming the connection groove 17.

Further, the laser light may be either irradiated from the side of the photovoltaic layer 13, or irradiated from the side of the transparent substrate 11A on the opposite side of the module, and there are no particular limitations in this regard.

In the case where irradiation is performed from the side of the transparent substrate 11A, the energy of the laser light is absorbed by the amorphous silicon layers of the photovoltaic layer 13, generating a high vapor pressure. This high vapor pressure can be utilized in etching the photovoltaic layer 13, meaning more stable laser etching processing can be performed.

The laser light is subjected to pulse oscillation within a range from approximately 10 kHz to approximately 20 kHz, and the laser power is adjusted so as to achieve a suitable process speed.

The position of the connection groove 17 is determined with due consideration of positioning tolerances, so as not to overlap with the transparent electrode layer slot 15 formed in a preceding step.

Fig. 8 and Fig. 9 are schematic illustrations describing a step of stacking a back electrode layer in the production process for the solar cell module of Fig. 2.

As illustrated in Fig. 8, following formation of the connection groove 17, the back electrode layer 14 is stacked on the photovoltaic layer 13. Specifically, the first back electrode layer 14A composed of a GZO film, and the second back electrode layer 14B composed of an Ag film and a Ti film, or an Ag film and an Al film, are stacked on the photovoltaic layer 13.

At this point, the back electrode layer 14 is also formed within the connection groove 17, forming a connection portion 18 that connects the transparent electrode layer 12 and the back electrode layer 14.

The first back electrode layer 14A is a Ga-doped ZnO film having a thickness of approximately 50 nm to approximately 100 nm, and is deposited using a sputtering apparatus.

The second back electrode layer 14B is deposited using a sputtering apparatus, under a reduced pressure atmosphere and under temperature conditions within a range from approximately 150°C to 200°C.

Specifically, an Ag film having a thickness within a range from approximately 150 nm to approximately 500 nm is deposited, and a Ti film having a thickness of approximately 10 nm to approximately 20 nm is then deposited on the Ag film. Alternatively, a stacked structure of an Ag film having a thickness of approximately 25 nm to 100 nm and an Al film having a thickness of approximately 15 nm to 500 nm may also be used.

As described above, by depositing the first back electrode layer 14A between the photovoltaic layer 13 (see Fig. 2) and the Ag film of the second back electrode layer 14B, the contact resistance between the photovoltaic layer 13 and the second back electrode layer 14B is reduced, and the degree of light reflection is improved.

Fig. 10 is a schematic illustration describing a step of producing an isolation groove in the production process for the solar cell module of Fig. 2.

As illustrated in Fig. 10, following stacking of the back electrode layer 14, an isolation groove 16 is formed.

Specifically, the transparent substrate 11A is mounted on an X-Y table, and the second harmonic of a laser diode excited YAG laser (532 nm) is irradiated through the transparent substrate 11A, as shown by the arrow in the figure. The irradiated laser light is absorbed by the photovoltaic layer 13, generating a high gas vapor pressure inside the photovoltaic layer 13. This gas vapor pressure removes the first back electrode layer 14A and the second back electrode layer 14B by explosive fracture.

The laser light is subjected to pulse oscillation within a range from approximately 1 kHz to approximately 50 kHz, and the laser power is adjusted so as to achieve a suitable process speed.

Fig. 11 is a schematic illustration describing a step of producing an insulation slot in the production process for the solar cell module of Fig. 2. Fig. 12 is an illustration of the solar cell module viewed from the back electrode layer side, describing the formation of the insulation slot of Fig. 11.

As illustrated in Fig. 11 and Fig. 12, following formation of the isolation groove 16, an insulation slot 19 is formed. The insulation slot 19 compartmentalizes the electric power generation region, thereby isolating and removing the effects of the serially connected portions at the film edges near the edges of the transparent substrate 11A that are prone to short circuits.

Fig. 11 represents an X-direction cross-sectional view cut along the direction of the series connection of the photovoltaic layer 13, and therefore the location in the figure where the insulation slot 19 is formed should actually appear as a peripheral film removed region 20 in which the back electrode layer 14 (the first back electrode layer 14A and the second back electrode layer 14B), the photovoltaic layer 13 and the transparent electrode layer 12 have been removed by film polishing (see Fig. 12), but in order to facilitate description of the processing of the edges of the transparent substrate 11A, this location in the figure represents a Y-direction cross-sectional view, so that the formed insulation slot represents the X-direction insulation slot 19.

When forming the insulation slot 19, the transparent substrate 11A is mounted on an X-Y table, and the second harmonic of a laser diode excited YAG laser (532 nm) is irradiated through the transparent substrate 11A. The irradiated laser light is absorbed by the transparent electrode layer 12 and the photovoltaic layer 13, generating a high gas vapor pressure. This gas vapor pressure removes the first back electrode layer 14A and the second back electrode layer 14B by explosive fracture, thus removing the back electrode layer 14 (the first back electrode layer 14A and the second back electrode layer 14B), the photovoltaic layer 13 and the transparent electrode layer 12.

The laser light is subjected to pulse oscillation within a range from approximately 1 kHz to approximately 50 kHz, and the laser power is adjusted so as to achieve a suitable process speed. The irradiated laser light is moved along the X-direction (see Fig. 12) at a position approximately 5 mm to 20 mm from the edge of the transparent substrate 11A.

At this time, a Y-direction insulation slot need not be provided, because a film surface polishing and removal treatment is conducted on the peripheral film removal region 20 of the transparent substrate 11A in a later step.

The insulation slot 19 is preferably formed at a position within a range from 5 mm to 15 mm from the edge of the transparent substrate 11A. By using this type of structure, external moisture can be inhibited from entering the interior of the solar cell module 2 via the edges of the solar cell panel.

Although the laser light used in the steps until this point has been specified as YAG laser light, the present invention is not limited to YAG lasers, and laser light from a YVO4 laser or fiber laser or the like may also be used in a similar manner.

Following formation of the insulation slot 19, the stacked films are removed from the periphery of the transparent substrate 11A (a peripheral film removal region 20). Namely, the first back electrode layer 14A, the second back electrode layer 14B, the photovoltaic layer 13 and the transparent electrode layer 12 are removed to form the peripheral film removed region 20. These stacked films tend to be uneven and prone to peeling, and therefore removing these stacked films ensures more favorable bonding of the back substrate 11B via an encapsulant sheet 25 in a subsequent step, thus achieving a more favorable sealed surface.

The stacked films mentioned above are removed from a region that is within a range from 5 mm to 20 mm from the edge of the transparent substrate 11A, around the entire periphery of the transparent substrate 11A, thus forming the peripheral film removed region 20.

In the X-direction, the stacked films are removed from the region closer to the substrate edge than the above-mentioned insulation slot 19 using grinding or blast polishing or the like. On the other hand, in the Y-direction, the stacked films are removed from the region closer to the substrate edge than the transparent electrode layer slot 15 using grinding or blast polishing or the like.

Grinding debris or abrasive grains generated during removal of the stacked films are removed by washing the transparent substrate 11A.

Fig. 13 is a schematic illustration describing the stacking of a back substrate and the like on the transparent substrate and the like of Fig. 12.

A terminal access hole 11H is provided in the back substrate 11B in a location corresponding with an attachment portion for a terminal box 31, and collecting plates 22B and 23B are accessible through this terminal access hole 11H. A waterproofing material 21 may also be provided inside this terminal access hole 11H. Providing such a waterproofing material is preferable, as it facilitates suppression of heating effects generated during the bonding such as soldering of the terminal box 31 described below, and also inhibits penetration of external moisture or the like into the solar cell module.

By using a pressure-sensitive adhesive-coated heat-resistant film (such as Kapton tape, which is composed of a polyimide film coated with a pressure-sensitive adhesive) as the waterproofing material 21, heating effects on an insulation sheet 24 are inhibited during the bonding of the terminal box 31 to the copper foil terminals 22B and 23B by soldering or the like, which is described below. Further, if a laminated structure prepared by laminating a pressure-sensitive adhesive-coated aluminum foil and a pressure-sensitive adhesive-coated PET sheet to another pressure-sensitive adhesive-coated PET sheet is used as the waterproofing material 21, then the effect of the waterproofing material 21 in preventing the penetration of external moisture and the like into the module at the terminal access hole 11H can be further enhanced.

The waterproofing material 21 may be excluded in those cases where there are no problems associated with preventing penetration of external moisture and the like at the terminal access hole 11H, and in those cases where there are no problems associated with heating effects on the insulation sheet 24 during the bonding of the terminal box 31 and the copper foil terminals 22B and 23B by soldering or the like.

Copper foil terminals 22A and 23A having a pressure-sensitive adhesive provided on the surface that faces the back electrode layer 14 are attached, respectively, to the back electrode layer 14 of the solar cell electric power generation cell 2S at one end of the plurality of series-connected electric power generation cells 2S, and the back electrode layer 14 of the current collection cell connected to the transparent electrode layer 12 of the solar cell electric power generation cell 2S at the other end. Each of the copper foil terminals 22A and 23A is subjected to a surface texturing treatment such as embossing on the surface to which the pressure-sensitive adhesive is applied, which facilitates the bonding and securing of the terminal to the back electrode layer 14 by the pressure-sensitive adhesive, and also enables a favorable electrical connection to the back electrode layer 14 through the pressure-sensitive adhesive.

Using the copper foil terminals 22A, 22B that extend from the electric power generation cell 2S at one end, and the copper foil terminals 23A, 23B that extend from the current collection cell connected to the electric power generation cell 2S at the other end, the generated electric power is collected at the terminal box 31 disposed on the back substrate 11B.

A pressure-sensitive adhesive is provided on the surfaces of the copper foil terminals 22B, 23B facing the back electrode layer 14, but because electrical connection with the back electrode layer 14 is not necessary, the surfaces of the copper foil terminals 22B, 23B to which the pressure-sensitive adhesive is applied need not be subjected to a surface texturing treatment such as embossing.

The insulation sheet 24 is disposed between the copper foil terminals 22B, 23B and the back electrode layer 14 to prevent electrical short circuits. The insulation sheet 24 is formed, for example, as a broad sheet that is wider than the copper foil terminals 22B, 23B, using a resin having insulating properties such as PET (polyethylene terephthalate). Moreover, a pressure-sensitive adhesive is provided on the surface of the insulation sheet 24 that faces the back electrode layer 14, and this pressure-sensitive adhesive is used to affix the insulation sheet 24.

Further, at the portion where the copper foil terminal 22B and the copper foil terminal 22A make electrical contact, the copper foil terminal 22B is disposed between the copper foil terminal 22A and the back electrode layer 14, thus achieving good electrical contact. Similarly, at the portion where the copper foil terminal 23B and the copper foil terminal 23A make electrical contact, the copper foil terminal 23B is disposed between the copper foil terminal 23A and the back electrode layer 14, thus achieving good electrical contact.

An output cable 32 from the terminal box 31 is connected electrically to the copper foil terminals 22B, 23B by soldering or the like, generating a structure that enables the collected electric power to be extracted.

The copper foil terminals 22A, 22B, 23A, 23B are formed using oxygen-free copper or tough pitch copper, and are formed as a foil having a thickness of approximately 20 µm to approximately 50 µm. Oxygen-free copper has less self-retained oxygen than tough pitch copper, and therefore forming the copper foil terminals 22A, 22B, 23A, 23B using oxygen-free copper is preferred, as it inhibits oxidation of the copper foil terminals 22A, 22B, 23A, 23B and enables the durability of the terminals to be better maintained.

A heat-resistant acrylic pressure-sensitive adhesive or a heat-resistant silicon-based pressure-sensitive adhesive is used as the pressure-sensitive adhesive to ensure that the adhesive can withstand the temperature of approximately 150°C to approximately 160°C used during lamination treatment. By affixing the copper foil terminals 22A, 22B, 23A, 23B and the insulation sheet 24 in a simple manner using a pressure-sensitive adhesive, workability is improved, and the members can be affixed without gaps forming between the affixed members. Accordingly, potential paths through which moisture can penetrate into the interior of the solar cell module 2 can be blocked, resulting in superior effects.

Furthermore, instead of affixing the above members using a pressure-sensitive adhesive, the bonding portions may be affixed using EVA, and the electrical contact portions may be affixed using a silver paste or the like.

Following provision of the copper foil terminals 22A, 22B, 23A, 23B used for current collection, the encapsulant sheet 25 (encapsulant) composed of EVA (ethylene-vinyl acetate copolymer) or the like and an inner periphery sealing material (inner seal portion) 26A are arranged in position (the positioning step).

The encapsulant sheet 25 covers the entire solar cell module 2, and is disposed in a region surrounded by the inner periphery sealing material 26A. As described above, each of the aforementioned members are positioned sequentially on top of the photovoltaic layer 13 and the back electrode layer 14 formed on the transparent substrate 11A, and the back substrate 11B is then positioned on top of the encapsulant sheet 25.

The inner periphery sealing material 26A prevents the encapsulant sheet 25 from protruding externally from between the transparent substrate 11A and the back substrate 11B, and also inhibits the penetration of moisture into the interior of the solar cell module 2 from the module periphery.

The inner periphery sealing material 26A is disposed on the edges of the transparent substrate 11A and the back substrate 11B, for example within the peripheral film removed region 20, and encapsulates the photovoltaic layer 13 and the like inside. A sealing material prepared using an elastic material such as butyl rubber, which has minimal moisture permeability and excellent durability, retains predetermined levels of hardness and elasticity even at the temperatures used during bonding in the laminator (approximately 150°C to approximately 160°C), and exhibits excellent adhesion to the transparent substrate 11A and the back substrate 11B can be used as the inner periphery sealing material 26A.

The inner periphery sealing material 26A is preferably either a hot melt material which can be applied and bonded by raising the temperature, and is applied around the periphery of the transparent substrate 11A using a conventional device such as a dispenser, or a preformed tape-based material which can be softened by raising the temperature, and is disposed around the periphery of the transparent substrate 11A.

A gap 26C that is formed as a notch in the inner periphery sealing material 26A is provided within the portion of the inner periphery sealing material 26A positioned along a short edge of the transparent substrate 11A and the back substrate 11B (the top edge in Fig. 13).

The gap 26C is a notch that links the region surrounded by the inner periphery sealing material 26A in which the encapsulant sheet 25 is disposed with the outside. The present embodiment describes an example in which the gap 26C is formed in substantially the center of the above-mentioned short edge.

Following positioning of the encapsulant sheet 25, the inner periphery sealing material 26A and the back substrate 11B in predetermined locations, a laminator is used to degas the area between the transparent substrate 11A and the back substrate 11B, and perform pressing at a temperature within a range from approximately 150°C to 160°C. This brings the back substrate 11B into close contact with the transparent substrate 11A, and causes cross-linking of the EVA of the encapsulant sheet 25, thereby bonding the back substrate 11B to the transparent substrate 11A (the sealing step).

The encapsulant sheet 25 is not limited to EVA, and an adhesive filler having similar functionality, such as PVB (polyvinyl butyral), may also be used. In such a case, the conditions employed such as the pressure bonding sequence, the temperature and the bonding time are optimized for the adhesive filler being used.

The air within the space surrounded by the transparent substrate 11A, the back substrate 11B and the inner periphery sealing material 26A is evacuated externally through the gap 26C. This external evacuation is the main purpose of the gap 26C, and therefore a gap of several cm (for example, approximately 1 cm to approximately 10 cm) is sufficient.

Fig. 14 is a schematic cross-sectional view describing a step of applying an outer sealing material in the production process for the solar cell module of Fig. 2.

Following bonding of the back substrate 11B to the transparent substrate 11A, an outer periphery sealing material (outer seal portion) 26B is disposed so as to cover the outside of the gap 26C, as illustrated in Fig. 14 (the outer periphery sealing step).

The outer periphery sealing material 26B fills the gap 26C, thus sealing the solar cell module 2 and preventing water or moisture from penetrating into the interior of the solar cell module 2 through the gap 26C.

A sealing material prepared using an elastic material such as butyl rubber, which has minimal moisture permeability and excellent durability, has a high viscosity, and exhibits excellent adhesion to the transparent substrate 11A and the back substrate 11B can be used as the outer periphery sealing material 26B.

The outer periphery sealing material 26B is applied using a conventional device such as a dispenser.

Fig. 15 is a schematic illustration describing a step of attaching a terminal box in the production process for the solar cell module of Fig. 2. Fig. 16 is a schematic illustration describing a sealing step in the production process for the solar cell module of Fig. 2.

As illustrated in Fig. 15, following bonding of the back substrate 11B, the terminal box 31 is attached to the back surface of the solar cell module 2 using an adhesive.

Subsequently, the copper foil terminals 22B, 23B are connected electrically to the output cable 32 from the terminal box 31 using solder or the like, and the interior of the terminal box 31 is then filled and sealed with a sealant (a potting material).

Fig. 17 is a schematic illustration describing a step of attaching long-side ribs and short-side ribs to the solar cell module.

As illustrated in Fig. 17, following completion of the attachment of the terminal box 31, the long-side ribs 3L and the short-side ribs 3S are attached to the solar cell module 2 (the rib attachment step).

The pair of long-side ribs 3L and the pair of short-side ribs 3S are fastened together using the bolts 3B to form a rectangular-shaped structure. Double-sided tape 3T is stuck to the back substrate 11B of the solar cell module 2 in positions that contact the long-side ribs 3L and the short-side ribs 3S, and this double-sided tape 3T and an adhesive (not shown in the figure) are used to affix the long-side ribs 3L and the short-side ribs 3S to the back substrate 11B of the solar cell module 2. The long-side ribs 3L and the short-side ribs 3S may be affixed using only an adhesive, but by also using the double-sided tape 3T, affixing the long-side ribs 3L and the short-side ribs 3S in the required bonding positions is simplified.

This completes the production of the solar cell panel 1.

There are no particular limitations on whether the double-sided tape 3T is stuck to the back substrate 11B, and the long-side ribs 3L and the short-side ribs 3S are then affixed to the back substrate 11B in the manner described above, or whether the double-sided tape 3T is stuck to the long-side ribs 3L and the short-side ribs 3S, and the long-side ribs 3L and the short-side ribs 3S are then affixed to the back substrate 11B.

According to the structure described above, the solar cell panel 1 is reinforced by bonding the long-side ribs 3L and the short-side ribs 3S to the back substrate 11B. As a result, the long-side ribs 3L and the short-side ribs 3S can function as members (strengthening members) that impart strength to the solar cell module 2, relative to loads that include both positive pressure caused by loads imparted to the light-incident surface of the solar cell panel 1 by wind blown onto the surface or snow accumulation on the surface, and negative pressure resulting from wind pressure due to wind blown onto the solar cell panel 1 from the opposite surface to the light-incident surface.

Accordingly, compared with the case where the long-side ribs 3L and the short-side ribs 3S are not used, the strength of the back substrate 11B itself may be quite low, enabling the thickness of the back substrate 11B to be reduced. As a result, the material costs for the back substrate 11B can be reduced, meaning the production costs of the solar cell panel 1 can also be reduced.

Moreover, by reducing the thickness of the back substrate 11B, the mass of the solar cell panel 1 can be reduced to produce a more lightweight structure, even allowing for the mass increase resulting from the long-side ribs 3L and the short-side ribs 3S, which improves handling of the solar cell panel 1 during production and installation.

In the structure described above, because the encapsulant sheet 25 is disposed in a space surrounded by the transparent substrate 11A, the back substrate 11B and the inner periphery sealing material 26A, the encapsulant sheet 25 can be prevented from protruding out from between the transparent substrate 11A and the back substrate 11B.

Moreover, because the inner periphery sealing material 26A is disposed between the transparent substrate 11A and the back substrate 11B, the inhibitory properties that inhibit moisture from penetrating into the interior of the solar cell module, namely the region in which the photovoltaic layer 13 is disposed, are able to be maintained, enabling the long-term reliability of the solar cell panel 1 to be improved.

On the other hand, during the process of sealing the photovoltaic layer 13 and the encapsulant sheet 25 and the like between the transparent substrate 11A and the back substrate 11B using a laminator, the air within the space surrounded by the transparent substrate 11A, the back substrate 11B and the inner periphery sealing material 26A can be evacuated rapidly through the gap 26C formed in the inner periphery sealing material 26A. As a result, the problem that arises when air bubbles are retained in the interior of the solar cell module 2, namely between the transparent substrate 11A and the back substrate 11B, and these retained air bubbles act as moisture penetration paths through which moisture can enter the interior of the solar cell module 2 from the module periphery can be suppressed, enabling the long-term reliability of the solar cell module 2 to be improved.

Generally, in the case of a large solar cell module 2 having a surface area exceeding 1 m², achieving a state of uniform pressure across the entire solar cell module 2 is difficult. However, in the present embodiment, a state of uniform pressure can be obtained across the entire solar cell module 2, meaning protrusion of the encapsulant sheet 25 beyond the solar cell module 2 and receding of the encapsulant sheet 25 inside the edge of the solar cell module 2 can be suppressed.

Moreover, evacuation of the air from the internal space inside the solar cell module 2 is simple, and retention of air bubbles inside the solar cell module 2 is inhibited. This enables the long-term reliability of the solar cell panel 1 to be improved.

Moreover, following the sealing of the photovoltaic layer 13 encapsulant sheet 25 and the like between the transparent substrate 11A and the back substrate 11B, the outer periphery of the gap 26C is covered with the outer periphery sealing material 26B, enabling sealing of the interior of the solar cell module 2.

In those cases where the solar cell panel 1 of the present embodiment is installed on an inclined installation surface, the solar cell panel 1 is preferably installed so that the gap 26C in the inner periphery sealing material 26A is positioned on the upper side of the inclined installation surface. This enables penetration of moisture into the interior of the solar cell module 2 to be better suppressed.

In other words, moisture such as rain water tends to penetrate between the solar cell module 2 and the frame that supports the solar cell module 2. In those cases where the solar cell panel 1 is installed on an inclined surface, and the installation and drainage structure of the solar cell panel 1 results in the generation of a moisture retention region at the bottom of the solar cell panel 1, moisture tends to accumulate at the bottom of the inclined surface. Accordingly, by positioning the gap 26C in the inner periphery sealing material 26A at the upper side of the installation surface, any accumulated water can be distanced from the gap 26C in the inner periphery sealing material 26A.

As a result, moisture penetration is prevented by the sealed structure formed from the continuous inner periphery sealing material 26A. Moreover, because the gap 26C in the inner periphery sealing material 26A is located in a position distant from the accumulated water, and the outer periphery of the gap 26C is covered by the outer periphery sealing material 26B, penetration of moisture into the interior of the solar cell module 2 can be prevented.

There are no particular limitations on the numbers of the long-side ribs 3L and the short-side ribs 3S, and the solar cell module 2 may be supported solely with the pair of long-side ribs 3L, 3L and the pair of short-side ribs 3S, 3S described in the above embodiment, or an additional short-side rib 3S may be provided between the pair of short-side ribs 3S, 3S, so that the solar cell module 2 is supported by a total of three short-side ribs 3S and the pair of long-side ribs 3L, 3L.

By using this type of structure, even in those cases where the installation configuration means that a high load due to snow accumulation or the like may be placed on the solar cell panel 1, the solar cell module 2 can be reliably supported without altering the thicknesses of the transparent substrate 11A and the back substrate 11B, simply by adjusting the numbers of the long-side ribs 3L and the short-side ribs 3S.

### Second Embodiment

A second embodiment of the present invention is described below with reference to Fig. 18.

The basic structure of the solar cell panel of this embodiment is the same as that of the first embodiment, but the locations of the gaps in the inner periphery sealing material differ from those of the first embodiment. Accordingly, for the present embodiment, the locations of the gaps in the inner periphery sealing material are described using Fig. 18, whereas descriptions of the other structural elements and the like are omitted.

Fig. 18 is a schematic illustration describing the locations of gaps in the inner periphery sealing material in a solar cell panel according to the present embodiment.

Those structural elements that are the same as elements in the first embodiment are labeled using the same reference signs, and their descriptions are omitted.

The positions of an inner periphery sealing material (inner seal portion) 126A and gaps 126C in a solar cell module 102 of a solar cell panel 101 according to the present embodiment are as illustrated in Fig. 18.

In other words, the inner periphery sealing material 126A is positioned along the long edges and the short edges of the transparent substrate 11A, and the gaps 126C are positioned at the four corners of the transparent substrate 11A.

In a similar manner to the inner periphery sealing material 26A of the first embodiment, the inner periphery sealing material 126A prevents the encapsulant sheet 25 from protruding externally from between the transparent substrate 11A and the back substrate 11B, and also inhibits the penetration of moisture into the interior of the solar cell module 2 from the module periphery. Moreover, the inner periphery sealing material 126A is a sealing material formed from the same material as that used for the inner periphery sealing material 26A of the first embodiment.

According to the configuration described above, by forming the gaps 126C at the corners of the transparent substrate 11A, namely at the corners of the inner periphery sealing material 126A, the inner periphery sealing material 126A can be positioned in a more stable manner.

For example, in those cases where the inner periphery sealing material 126A is formed by application using a dispenser or the like, the corners where the direction of application changes tend to be prone to non-uniformity in the thickness of the applied inner periphery sealing material 126A, or non-uniformity in the shape of the inner periphery sealing material 126A. By forming the gaps 126C at the corners of the inner periphery sealing material 126A, the inner periphery sealing material 126A need not be provided at the corners, where formation tends to be difficult, meaning the uniformity of the thickness and shape of the inner periphery sealing material 126A can be more readily maintained.

On the other hand, by providing the gaps 126C in the inner periphery sealing material 126A at each of the corners of the inner periphery sealing material 126A, the air within the space surrounded by the transparent substrate 11A, the back substrate 11B and the inner periphery sealing material 126A can be evacuated more uniformly and more rapidly in the laminator than a case such as the first embodiment, where the gap 26C is provided in only a single location.

Accordingly, retention of air bubbles within the interior of the solar cell module 2, namely within the space between the transparent substrate 11A and the back substrate 11B, can be better suppressed. As a result, penetration of moisture into the interior of the solar cell module 2 from the module periphery caused by retained air bubbles acting as moisture penetration paths is inhibited, meaning the long-term reliability of the solar cell module 2 can be improved.

### Third Embodiment

A third embodiment of the present invention is described below with reference to Fig. 19 to Fig. 22.

The basic structure of the solar cell panel of this embodiment is the same as that of the first embodiment, but differs from the first embodiment in that no inner periphery sealing material is provided, with an outer sealing material instead being provided around the entire periphery, and also differs in terms of the method used for bonding the transparent substrate and the back substrate using the laminator. Accordingly, for the present embodiment, only the method used for bonding the transparent substrate and the back substrate using the laminator is described with reference to Fig. 19 to Fig. 22, whereas descriptions of the other structural elements and the like are omitted.

Fig. 19 is a schematic illustration describing stacking of the back substrate and the like on the transparent substrate and the like in a solar cell panel according to the present embodiment.

Those structural elements that are the same as elements in the first embodiment are labeled using the same reference signs, and their descriptions are omitted.

The configuration between the transparent substrate 11A having the photovoltaic layer 13 and the like deposited thereon and the back substrate 11B in a solar cell module 202 of a solar cell panel 201 according to the present embodiment is as illustrated in Fig. 19.

In other words, the waterproofing material 21, the copper foil terminals 22A, 22B, 23A, 23B, the insulation sheet 24, and the encapsulant sheet 25 are positioned in the same manner as the first embodiment. Namely, with the exception of not providing the inner periphery sealing material 26A, the configuration and positioning of the various elements are the same as the first embodiment.

Following positioning of the encapsulant sheet 25 and the like in their predetermined locations, a laminator 250 described below is used to bond the transparent substrate 11A and the back substrate 11B.

The structure of the laminator 250 is described below.

Fig. 20 is a schematic illustration describing the structure of the laminator.

The laminator 250 is used for bonding and sealing the transparent substrate 11A and the back substrate 11B. As illustrated in Fig. 20, the laminator 250 comprises an upper half unit 251U and a lower half unit 251L.

The upper half unit 251U is used for evacuating the internal air from between the transparent substrate 11A and the back substrate 11B, which are positioned between the upper half unit 251U and the lower half unit 251L, prior to bonding, and also for applying pressure and heat to bond and seal the structure. The upper half unit 251U is able to be moved towards and away from the lower half unit 251L, meaning pressure can be applied to the transparent substrate 11A and the back substrate 11B by moving the upper half unit 251U closer to the lower half unit 251L.

The upper half unit 251U comprises mainly an upper chamber 252U, a diaphragm press sheet 253U, and a release sheet 254U.

The upper chamber 252U, together with a lower chamber 252L, forms a sealed container that houses the transparent substrate 11A and the back substrate 11B and the like. Moreover, the upper chamber 252U, together with the release sheet 254U, forms the external shape of the upper half unit 251U, and is used for supporting the release sheet 254U. The upper chamber 252U has a shape that includes a recessed portion which is formed in the central region of a flat plate and steps away from the lower half unit 251L (in the upward direction in Fig. 20).

The upper chamber 252U is also provided with an upper atmospheric vent 261U and an upper vacuum evacuation port 262U.

The upper atmospheric vent 261U and the upper vacuum evacuation port 262U are connected to an upper space US between the recessed portion of the upper chamber 252U and the diaphragm press sheet 253U.

The upper atmospheric vent 261U connects the upper space US with the external atmosphere, and includes a flow path and an on-off valve.

The upper vacuum evacuation port 262U connects the upper space US to a vacuum pump (not shown in the figure), and includes a flow path and an on-off valve.

The diaphragm press sheet 253U presses the release sheet 254U onto the transparent substrate 11A and the back substrate 11B, and also forms the upper space US within the recessed portion of the upper chamber 252U.

The release sheet 254U prevents adhesion, namely adhesion caused by protruding EVA, between the bonded transparent substrate 11A and back substrate 11B and the like, and the diaphragm press sheet 253U provided in the upper half unit 251U, and thus facilitates release of the solar cell module.

The release sheet 254U is disposed between the upper chamber 252U and the lower half unit 251L, and the two ends of the release sheet 254U are wound on to a pair of rollers positioned on opposing sides of the upper chamber 252U, so that the release sheet 254U is moved by a fixed amount after each lamination treatment. This prevents any protruding EVA from accumulating on the release sheet 254U and impairing the subsequent lamination treatment.

The lower half unit 251L is used for evacuating the internal air from between the transparent substrate 11A and the back substrate 11B, which are positioned between the upper half unit 251U and the lower half unit 251L, prior to bonding, and also for applying pressure and heat to bond and seal the structure. The lower half unit 251L is sandwiched between substrate transport rollers 270, 270, and is positioned so as to enable transport of the transparent substrate 11A and the back substrate 11B and the like between the substrate transport rollers 270.

The lower half unit 251L comprises mainly the lower chamber 252L, a hot plate 253L, a transport unit 254L, and pillows 255L.

The lower chamber 252L, together with the upper chamber 252U, forms a sealed container. Further, the lower chamber 252L, together with the transport unit 254L, forms the external shape of the lower half unit 251L, with the hot plate 253L supported therein. The lower chamber 252L has a shape that includes a recessed portion which is formed in the central region of a flat plate and steps away from the upper half unit 251U (in the downward direction in Fig. 20).

The lower chamber 252L is also provided with a lower atmospheric vent 261L and a lower vacuum evacuation port 262L.

The lower atmospheric vent 261L and the lower vacuum evacuation port 262L are connected to the internal space of the sealed container formed by the upper chamber 252U and the lower chamber 252L.

The lower atmospheric vent 261L connects the sealed space with the external atmosphere, and includes a flow path and an on-off valve.

The lower vacuum evacuation port 262L connects the sealed space to a vacuum pump (not shown in the figure), and includes a flow path and an on-off valve.

The hot plate 253L heats the transparent substrate 11A and the back substrate 11B and the like, and in particular the encapsulant sheet 25. The hot plate 253L is disposed inside the recessed portion of the lower chamber 252L, and is able to transmit heat to the back substrate 11B and the like via the transport unit 254L.

The present embodiment describes an example in which the hot plate 253L is heated to approximately 150°C, but the temperature is not limited to this particular value.

The transport unit 254L transports the transparent substrate 11A and the back substrate 11B between the substrate transport rollers 270. The transport unit 254L is provided with a transport belt 256L that is disposed in an annular arrangement around the periphery of the lower chamber 252L, and belt rollers 257L that support the transport belt 256L.

The transparent substrate 11A and the back substrate 11B and the like are transported by moving the transport belt 256L around the periphery of the lower chamber 252L with the transparent substrate 11A and the back substrate 11B and the like supported thereon.

The belt rollers 257L support the transport belt 256L in a manner that enables the transport belt 256L to be moved around the periphery of the lower chamber 252L.

The pillows 255L are used for specifying the spacing between the transparent substrate 11A and the back substrate 11B when the transparent substrate 11A and the back substrate 11B are subjected to pressing. The pillows 255L have a substantially rectangular column shape, and are disposed between the upper half unit 251U and the lower half unit 251L.

The height of the pillows 255L in the vertical direction (the up-down direction in Fig. 20) is equal to the combined thicknesses of the transparent substrate 11A and the back substrate 11B, plus the spacing between the transparent substrate 11A and the back substrate 11B.

Next is a description of a process for bonding the transparent substrate 11A and the back substrate 11B using the laminator 250 described above.

First, as illustrated in Fig. 19, the waterproofing material 21, the copper foil terminals 22A, 23A, the insulation sheet 24, the copper foil terminals 22B, 23B and the encapsulant sheet 25 and the like, and finally the back substrate 11B, are positioned on the upper surface of the transparent substrate 11A having the photovoltaic layer 13 and the like deposited thereon (the positioning step).

The waterproofing material 21 may be excluded in those cases where there is no necessity to prevent penetration of external moisture and the like at the terminal access hole 11H, and in those cases where there is no necessity to inhibit heating effects that may occur during bonding by soldering or the like.

The steps prior to the positioning step are the same as those described for the first embodiment, and therefore their description is omitted here.

Subsequently, the transparent substrate 11A having the encapsulant sheet 25 and the like positioned thereon and the back substrate 11B are transported to the laminator 250 by the substrate transport rollers 270, as illustrated in Fig. 20.

Using the transport unit 254L of the laminator 250, the transparent substrate 11A having the encapsulant sheet 25 and the like positioned thereon and the back substrate 11B are positioned between the lower half unit 251L and the upper half unit 251U.

The pillows 255L are then positioned adjacent to the transparent substrate 11A and the back substrate 11B. The pillows 255L are installed around the periphery of the transparent substrate 11A and the back substrate 11B, and are preferably positioned at the corners and in the central region of the long-side edges.

The upper half unit 251U is then brought closer to the lower half unit 251L, thereby sealing the upper chamber 252U and the lower chamber 252L, and encapsulating the transparent substrate 11A having the encapsulant sheet 25 and the like positioned thereon and the back substrate 11B inside the sealed space.

During the period when the transparent substrate 11A having the encapsulant sheet 25 and the like positioned thereon and the back substrate 11B are being transported, the upper atmospheric vent 261U and the lower atmospheric vent 261L are open.

In other words, the upper space US is open to the atmosphere, and the sealed space between the upper chamber 252U and the lower chamber 252L is also open to the atmosphere.

Next, the transparent substrate 11A and the back substrate 11B are subjected to evacuation of internal air, pressing, and heating.

Specifically, the pressing of the transparent substrate 11A and the back substrate 11B is performed in the manner described below. Namely, the previously open upper atmospheric vent 261U and lower atmospheric vent 261L are closed, while the upper vacuum evacuation port 262U and the lower vacuum evacuation port 262L are opened, and the vacuum pump is used to evacuate the air from inside the upper space US and the sealed space.

This degases the area between the transparent substrate 11A and the back substrate 11B.

Subsequently, only the upper vacuum evacuation port 262U is closed, and the upper atmospheric vent 261U is opened again. This raises the pressure inside the upper space US to atmospheric pressure, and the pressure difference between the upper space US and the sealed space causes the diaphragm press sheet 253U to press down upon the transparent substrate 11A and the back substrate 11B. In other words, pressing of the transparent substrate 11A and the back substrate 11B is performed by pressing upon the back substrate 11B with the diaphragm press sheet 253U.

On the other hand, the transparent substrate 11A and the back substrate 11B are pressed strongly against the hot plate 253L. As a result, the heat from the hot plate 253L passes through the transport belt 256L and the transparent substrate 11A and is transmitted to the encapsulant sheet 25. As a result of the above actions, the back substrate 11B is pressed tightly against the transparent substrate 11A, and the EVA of the encapsulant sheet 25 undergoes cross-linking, thereby bonding and sealing the back substrate 11B and the transparent substrate 11A (the sealing step).

At this time, the transparent substrate 11A and the back substrate 11B are pressed down to the height of the pillows 255L, whereas beyond that point, the diaphragm press sheet 253U is supported by the pillows 255L.

Following completion of the bonding of the transparent substrate 11A and the back substrate 11B, the lower vacuum evacuation port 262L is closed and the lower atmospheric vent 261L is opened, thus opening the sealed space to the atmosphere. As a result, the pressure of the diaphragm press sheet 253U on the back substrate 11B is halted. Subsequently, the upper half unit 251U is moved upward and away from the lower half unit 251L.

At this time, because the release sheet 254U is positioned in the location where the upper half unit 251U makes contact with the transparent substrate 11A and the back substrate 11B, adhesion of the transparent substrate 11A and the back substrate 11B to the upper half unit 251U due to protruding EVA does not occur.

The pillows 255L positioned adjacent to the transparent substrate 11A and the back substrate 11B are then removed from the laminator 250, and the transport unit 254L is used to transport the transparent substrate 11A and the back substrate 11B out to the substrate transport rollers 270.

Fig. 21 is a schematic illustration describing a step of applying the outer sealing material. Fig. 22 is a schematic illustration describing a different structural state for the outer sealing material from the structural state illustrated in Fig. 21.

Following bonding of the back substrate 11B and the transparent substrate 11A, the outer periphery sealing material 26B is positioned so as to cover the outer periphery of the space between the transparent substrate 11A and the back substrate 11B (the outer periphery sealing step), as illustrated in Fig. 21.

Further, the outer periphery sealing material 26B may also be applied in the manner illustrated in Fig. 22, so that rather than covering only a portion of the side edges of the back substrate 11B and the transparent substrate 11A, the outer periphery sealing material 26B covers the entire side edges and also wraps slightly around onto the side of the back substrate 11B, thereby improving the sealing properties. In this case, careful consideration must be given to the amount of wrap around, so as to avoid obstructing installation of the long-side ribs 3L.

The outer periphery sealing material 26B fills the space between the transparent substrate 11A and the back substrate 11B, thus yielding better sealing properties for the solar cell module 202, and better preventing water or moisture from penetrating into the interior of the solar cell module 202.

The subsequent steps are the same as those described for the first embodiment, and therefore their description is omitted here.

According to the structure described above, because the substrate spacing between the transparent substrate 11A and the back substrate 11B is unable to narrow beyond a predetermined spacing specified by the pillows 255L when the pressing force is applied during the lamination step, the problem that arises when the encapsulant sheet 25 is pushed out and protrudes between the transparent substrate 11A and the back substrate 11B during the sealing step can be effectively prevented.

The specified predetermined spacing is typically within a range from approximately 0.3 mm to approximately 1.0 mm. The required substrate spacing specified by the predetermined spacing can be set with a precision of approximately ±0.1 mm in accordance with the thickness of the encapsulant sheet 25 and the pressing condition employed during the lamination step.

Moreover, when the pressing force is removed following completion of the sealing step, there are no portions where the substrate spacing between the transparent substrate 11A and the back substrate 11B has narrowed excessively beyond the above-mentioned specified predetermined spacing, and therefore there is no significant widening of the substrate spacing. As a result, the problem that arises when the encapsulant sheet 25 is drawn back into the space between the transparent substrate 11A and the back substrate 11B can be prevented, preventing the formation of recesses in the encapsulant sheet 25 around the periphery of the solar cell module 202.

Accordingly, penetration of moisture into the interior of the solar cell module 202 from the module periphery can be suppressed, and the long-term reliability of the solar cell module 202 can be improved.

### Fourth Embodiment

A fourth embodiment of the present invention is described below with reference to Fig. 23.

The basic structure of the solar cell panel of this embodiment is the same as that of the third embodiment, but differs from the third embodiment in terms of the method used for bonding the transparent substrate and the back substrate using the laminator. Accordingly, for the present embodiment, only the method used for bonding the transparent substrate and the back substrate using the laminator is described with reference to Fig. 23, whereas descriptions of the other structural elements and the like are omitted.

Fig. 23 is a schematic illustration describing the structure of a laminator according to the present embodiment.

Those structural elements that are the same as elements in the third embodiment are labeled using the same reference signs, and their descriptions are omitted.

A laminator 350 is used for bonding the transparent substrate 11A and the back substrate 11B. As illustrated in Fig. 23, the laminator 350 comprises the upper half unit 251U and a lower half unit 351L.

The lower half unit 351L is used for evacuating the internal air from between the transparent substrate 11A and the back substrate 11B, which are positioned between the upper half unit 251U and the lower half unit 351L, prior to bonding, and also for applying pressure and heat to bond and seal the structure. The lower half unit 351L is sandwiched between substrate transport rollers 270, 270, and is positioned so as to enable transport of the transparent substrate 11A and the back substrate 11B and the like between the substrate transport rollers 270.

The lower half unit 351L comprises mainly the lower chamber 252L, the hot plate 253L, the transport unit 254L, and spacers (pillows) 355L.

The spacers 355L are used for specifying the spacing between the transparent substrate 11A and the back substrate 11B when the transparent substrate 11A and the back substrate 11B are subjected to pressing. The spacers 355L are disposed between the upper half unit 251U and the lower half unit 351L.

The spacers 355L are each provided with a protrusion 356L which, when the spacer is disposed between the upper half unit 251U and the lower half unit 351L, protrude in the horizontal direction (the left-right direction in Fig. 23).

These protrusions 356L are inserted between the transparent substrate 11A and the back substrate 11B, thereby specifying the spacing between the transparent substrate 11A and the back substrate 11B. Accordingly, the height dimension of the protrusions 356L in the vertical direction (the up-down direction in Fig. 23) is determined by the spacing between the transparent substrate 11A and the back substrate 11B.

Next is a description of a process for bonding the transparent substrate 11A and the back substrate 11B using the laminator 350 described above.

The steps up to and including the positioning of the transparent substrate 11A having the encapsulant sheet 25 and the like deposited thereon and the back substrate 11B between the lower half unit 351L and the upper half unit 251U using the transport unit 254L of the laminator 350 are performed in the same manner as that described for the third embodiment, and their description is therefore omitted.

Unlike the pillows 255L of the third embodiment, the spacers 355L of the present embodiment are then positioned so that the protrusions 356L are inserted inside the gap between the transparent substrate 11A and the back substrate 11B. The spacers 355L are installed at positions around the entire periphery of the transparent substrate 11A and the back substrate 11B, and are preferably positioned at the corners and in the central region of the long-side edges.

By adopting this configuration, when the transparent substrate 11A and the back substrate 11B are subjected to pressing, the opposing surfaces of the transparent substrate 11A and the back substrate 11B are pressed closer together, until making contact with the protrusions 356L. Once the transparent substrate 11A and the back substrate 11B have made contact with the protrusions 356L, the back substrate 11B moves no closer to the transparent substrate 11A even if subjected to pressing by the diaphragm press sheet 253U.

The remaining steps are performed in the same manner as that described for the third embodiment, and their description is therefore omitted.

According to the structure described above, because the spacing between the transparent substrate 11A and the back substrate 11B is unable to narrow beyond a predetermined spacing specified by the protrusions 356L of the spacers 355L, the problem that arises when the encapsulant sheet 25 is pushed out and protrudes between the transparent substrate 11A and the back substrate 11B during the sealing step can be effectively prevented.

Moreover, when the pressing force is removed following completion of the sealing step, the spacing between the transparent substrate 11A and the back substrate 11B undergoes no significant widening, and therefore the problem that arises when the encapsulant sheet 25 is drawn back into the space between the transparent substrate 11A and the back substrate 11B can be prevented, preventing the formation of recesses in the encapsulant sheet 25 around the periphery of the solar cell module 202.

Accordingly, penetration of moisture into the interior of the solar cell module 202 from the module periphery can be suppressed, and the long-term reliability of the solar cell module 202 can be improved.

### Fifth Embodiment

A fifth embodiment of the present invention is described below with reference to Fig. 24.

The basic structure of the solar cell panel of this embodiment is the same as that of the first embodiment, but differs from the first embodiment in terms of the positioning of the inner periphery sealing material. Accordingly, for the present embodiment, only the locations of the gaps in the inner periphery sealing material are described with reference to Fig. 24, whereas descriptions of the other structural elements and the like are omitted.

Fig. 24 is a schematic illustration describing the locations of gaps in the inner periphery sealing material in a solar cell panel according to the present embodiment.

Those structural elements that are the same as elements in the first embodiment are labeled using the same reference signs, and their descriptions are omitted.

The positioning of an inner periphery sealing material (inner seal portion) 326A in a solar cell module 302 of a solar cell panel 301 according to the present embodiment is as illustrated in Fig. 24.

Namely, the inner periphery sealing material 326A is positioned along the entire length of either the long sides or the short sides of the transparent substrate 11A. In other words, gaps 326C are formed across the entire width of the short sides or the long sides where the periphery sealing material 326A is not provided.

In a similar manner to the inner periphery sealing material 26A of the first embodiment, the inner periphery sealing material 326A prevents the encapsulant sheet 25 from protruding externally from between the transparent substrate 11A and the back substrate 11B. The inner periphery sealing material 326A is a sealing material formed from the same material as that used for the inner periphery sealing material 26A of the first embodiment.

According to the structure described above, because the inner periphery sealing material 326A need only be positioned along the two opposing long-side or short-side edges of the transparent substrate 11A, positioning of the inner periphery sealing material 326A is comparatively simple. In cases such as the present embodiment, where the inner periphery sealing material 326A is applied using a dispenser, because the direction of movement of the dispenser is restricted, the drive mechanism for the dispenser can be simplified.

### Reference Signs List

- 1, 101, 201, 301: Solar cell panel
- 2, 102, 202, 302: Solar cell module
- 3L, 3L: Long-side rib (rib)
- 3S, 3S: Short-side rib (rib)
- 11A: Transparent substrate
- 13: Photovoltaic layer
- 11B: Back substrate
- 25: Encapsulant sheet (encapsulant)
- 26A, 126A, 326A: Inner periphery sealing material (inner seal portion)
- 26C, 126C, 326C: Gap
- 26B: Outer periphery sealing material (outer seal portion)
- 255L: Pillow
- 355L: Spacer (pillow)

## Claims

1. A solar cell module, comprising:
a transparent substrate and a back substrate that are disposed with a photovoltaic layer sandwiched therebetween,
an inner seal portion that is disposed between the transparent substrate and the back substrate and surrounds a periphery of a region between the transparent substrate and the back substrate,
an encapsulant that is disposed inside a region surrounded by the transparent substrate, the back substrate and the inner seal portion,
a gap that is formed in a portion of the inner seal portion and links the region in which the encapsulant is disposed with the outside, and
an outer seal portion that covers the gap.

2. The solar cell module according to claim 1, wherein the gap is provided in only a single location within the inner seal portion.

3. The solar cell module according to claim 1, wherein the gap is provided at a corner of the inner seal portion.

4. The solar cell module according to claim 1, wherein the inner seal portion is disposed along one pair of opposing sides of the transparent substrate and the back substrate, and the gap is provided along another pair of opposing sides.

5. A solar cell panel, comprising:
the solar cell module according to any one of claim 1 to claim 4, and
ribs that are affixed to the back substrate of the solar cell module and support the solar cell module.

6. A process for producing a solar cell module, the process comprising:
a deposition step of forming a photovoltaic layer on a transparent substrate,
a positioning step of positioning an inner seal portion around a periphery of the transparent substrate, forming a notch-shaped gap in a portion of the inner seal portion, and positioning an encapsulant inside a region surrounded by the inner seal portion, and
a sealing step of positioning a back substrate so as to sandwich the inner seal portion and the encapsulant between the transparent substrate and the back substrate, evacuating air from a space surrounded by the inner seal portion, and heat-sealing the encapsulant to seal the transparent substrate and the back substrate.

7. A process for producing a solar cell module, the process comprising:
a deposition step of forming a photovoltaic layer on a transparent substrate,
a positioning step of positioning an encapsulant so as to cover the photovoltaic layer on the transparent substrate, and
a sealing step of positioning a back substrate so as to sandwich the photovoltaic layer and the encapsulant between the transparent substrate and the back substrate, positioning a pillow that specifies a spacing between the transparent substrate and the back substrate along at least a portion of a periphery of the transparent substrate, evacuating air from a space between the transparent substrate and the back substrate, and heat-sealing the encapsulant to seal the transparent substrate and the back substrate.

8. The process for producing a solar cell module according to claim 6 or claim 7, wherein
the sealing step comprises an outer periphery sealing step of positioning an outer seal portion so as to cover an outer periphery of a region between the transparent substrate and the back substrate in which the inner seal portion has not been provided.

9. A process for producing a solar cell panel, the process comprising:
a rib attachment step, which is performed following the sealing step of the process for producing a solar cell module according to any one of claim 6 to claim 8, and comprises attaching ribs that support the solar cell module to the back substrate.
